(19) Europäisches Patentamt
European Patent Office
Office européen des brevets

(11) **EP 4 080 527 B1**

(12) **EUROPEAN PATENT SPECIFICATION**

(45) Date of publication and mention
of the grant of the patent:
**21.06.2023 Bulletin 2023/25**

(21) Application number: **21169465.8**

(22) Date of filing: **20.04.2021**

(51) International Patent Classification (IPC):
$H01F\ 6/00$ (2006.01)    $H01F\ 13/00$ (2006.01)
$G01R\ 33/38$ (2006.01)    $G01R\ 33/3815$ (2006.01)

(52) Cooperative Patent Classification (CPC):
**H01F 6/00; H01F 13/003;** G01R 33/38;
G01R 33/3804; G01R 33/3815

(54) **METHOD FOR CHARGING A SUPERCONDUCTOR MAGNET SYSTEM, WITH SEQUENTIAL COOLING OF SUPERCONDUCTOR BULK SUB-MAGNETS**

VERFAHREN ZUM LADEN EINES SUPRALEITERMAGNETSYSTEMS MIT SEQUENZIELLER KÜHLUNG VON SUPRALEITERMASSENUNTERMAGNETEN

PROCÉDÉ POUR CHARGER UN SYSTÈME D'AIMANT SUPRACONDUCTEUR AVEC SYSTÈME DE REFROIDISSEMENT SÉQUENTIEL AVEC DES SOUS-AIMANTS SUPRACONDUCTEURS EN VRAC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.10.2022 Bulletin 2022/43**

(73) Proprietor: **Bruker Switzerland AG**
**8117 Fällanden (CH)**

(72) Inventors:
• **Hinderer, Jörg**
**79761 Waldshut-Tiengen (DE)**

• **Heiss, Stephan**
**8542 Wiesendangen (CH)**

(74) Representative: **Kohler Schmid Möbus**
**Patentanwälte**
**Partnerschaftsgesellschaft mbB**
**Gropiusplatz 10**
**70563 Stuttgart (DE)**

(56) References cited:
**EP-B1- 3 657 193**    **JP-B2- 5 143 006**
**US-A1- 2019 178 961**    **US-B2- 8 948 829**

**Description**

The invention relates to a method for charging a superconductor magnet system, with the superconductor magnet system comprising

- a superconductor bulk magnet, with the superconductor bulk magnet comprising N superconductor bulk sub-magnets, with $N \geq 4$,
- and a cooling system for the N superconductor bulk sub-magnets,

wherein the superconductor bulk magnet is arranged in a charger bore of an electrical charger magnet,
wherein the N superconductor bulk sub-magnets are charged by a field cooling process, such that a target persistent current pattern $\underline{i}^{target} = (i_n: n=1...N)$ in the superconductor bulk sub-magnets is achieved, wherein an electric current $I_{ch}$ in the electrical charger magnet is changed, with n: superconductor bulk sub-magnet index.

Such a method is known from US 2019/0178961 A1.

Superconductors may carry an electrical current at practically no ohmic losses. Superconductors are, for example, used to generate magnetic fields of high strength, in particular for use in nuclear magnetic resonance (=NMR) applications. Superconductors have to be exposed to cryogenic temperatures, though, since superconductivity is only assumed below a critical temperature $T_c$, which is specific for the superconductor material. Accordingly, superconductors are typically arranged in a cryostat for thermal insulation.

Common superconductor applications use superconductor lines, such as tape shaped or wire shaped superconductor lines. The superconductor lines may be used directly (for example for current transport) or after having been brought in a desired form, for example by winding coils. In particular, superconductor coils for high field applications are typically made from superconductor lines wound in a solenoid type fashion.

However, superconductor bulk magnets are also known. In this case, a superconducting current circulates inside a piece or stacked pieces of superconductor, with the superconductor bulk magnet in general being of closed ring shape. Such structures are simple and inexpensive to produce, and are often made from high temperature superconductor (=HTS) material.

Superconductor bulk magnets may be loaded by a procedure called "field cooling", e.g. described in US 7,859,374 B2. For this procedure, the superconductor bulk magnet is disposed inside the charger bore of an electrical charger magnet, and then the charger magnet is turned on and generates a magnetic field while the superconductor bulk magnet's temperature T is still above the critical temperature $T_c$. Then the superconductor bulk magnet is cooled below $T_c$ and becomes superconducting. Subsequently, with T kept below $T_c$, the charger magnet is turned off; by this means, a current is induced in the superconductor bulk magnet, such that the magnetic flux within the superconductor bulk magnet is maintained. In other words, the superconductor bulk magnet traps the magnetic field in its inside. Then the superconductor bulk magnet may be removed from the charger magnet, and may be transported to a place where the trapped magnetic field may be used.

For many applications, such as said NMR applications, a high homogeneity of a magnetic field is desirable. However, the typical magnetic field of a superconductor bulk magnet magnetized via the field cooling process and provided in its superconductor bore has a relatively low homogeneity.

It is well known to use resistive electrical shim coils to correct an inhomogeneous magnetic field during its use, such as during NMR measurements. However, shim coils require valuable space within the superconductor bore which could otherwise be used for a sample material to be investigated. Furthermore, shim coils generate significant heat, what may also limit the degree of inhomogeneity that can be corrected at all.

In US 2019/0178961 A1, a bulk magnet structure is proposed, comprising a plurality of stacked, ring-shaped oxide superconducting bulk bodies. The bulk magnetic structure has a common cooling stage, which is equipped with a heater, for globally controlling the temperature of the ring-shaped oxide superconducting bulk bodies. A reinforcing ring is fitted to the outer circumferential surface of the plurality of the ring-shaped oxide superconducting bulk bodies. In one embodiment, an axially central ring-shaped oxide bulk body has a largest inner diameter, and axially to the outside, the inner diameters of the ring-shaped oxide bulk bodies decrease.

EP 3 657 193 B1 proposes a method for magnetizing a superconductor bulk magnet, wherein both a charger magnet arranged radially outside the bulk magnet and a field correction unit arranged at least partially within a bore of the bulk magnet are applied during field cooling.

US 8,948,829 B2 suggests an oxide superconducting bulk magnet comprising a plurality of radially nested bulk sections, arranged in an axial stack.

In post-published European patent application 20 174 683.1, a field cooling procedure has been proposed for a superconductor bulk magnet having a plurality of bulk sub-magnets the temperatures of which can be independently controlled. The field cooling procedure comprises a preparatory step and a main field cooling step. During the preparatory field cooling step, at least temporarily at least a part of the bulk sub-magnets is magnetically saturated, such that preparatory currents according to a correction scheme (here also called a target persistent current pattern) are induced. In the main field cooling step following the preparatory step, none of the bulk sub-magnets is magnetically saturated, so the bulk sub-magnets are charged with main currents according to a basic distribution scheme (here also called main persistent current pattern). The preparatory currents and the main currents add up, and a magnetic field profile more homogeneous than based on the main currents alone can be achieved. For individually setting the temperatures of the bulk sub-magnets, for each bulk sub-magnet, a thermal switch to a common cooling stage, an electrical heater and a temperature sensor are proposed.

Although requiring particular equipment for individually setting the temperatures of the bulk sub-magnets, this method can in principle compensate even large and complex inhomogeneities of the magnetic field originating from the main currents. Compensating low order gradients (first or second order) involving a low number of bulk sub-magnets (such as up to three bulk sub-magnets) can be achieved by setting the required amplitudes of the preparatory currents iteratively by trial and error. However, setting individual preparatory currents for a larger number of bulk sub-magnets, such as of four or more bulk sub-magnets, becomes more and more difficult.

The publicly available software "LTspice", compare https://www.analog.com/en/design-center/design-tools-and-calculators/ltspice-simulator.html as of March 29, 2021, can calculate R-L-networks forward in time.

Object of the invention

It is the object of the present invention to present a method for charging a superconductor magnet system as introduced in the beginning, wherein setting a desired target persistent current pattern (or preparatory currents according to a desired correction scheme) can be accomplished easily, in particular for a larger number of bulk sub-magnets.

Short description of the invention

This object is achieved, in accordance with the invention, by a method as introduced in the beginning, characterized in

that the cooling system is adapted to individually set temperatures $T_n$ of the N superconductor bulk sub-magnets,

that during the field cooling process, at least temporarily the temperatures $\underline{T}=(T_n: n=1...N)$ of the N superconductor bulk sub-magnets (6a-6j) are chosen different from each other,

that in an advance calculation, the following steps are applied:

a) a temporal sequence of cooling steps $cs_k$ is chosen, wherein starting from a state of the superconductor bulk magnet with all its superconductor bulk sub-magnets above their critical temperature $T_c$, in each cooling step $cs_k$ of the temporal sequence, one more superconductor bulk sub-magnet is cooled below its critical temperature $T_c$, with k: sequence index, with k=1...N;

b) for each state $st_k$ of the superconductor bulk magnet obtained after a respective cooling step $cs_k$, a distribution of temperatures $\underline{T}(k)$ of the superconductor bulk sub-magnets is determined, with $\underline{T}(k)=(T_n(k): n=1...N)$,

c) for each state $st_k$ of the superconductor bulk magnet obtained after a respective cooling step $cs_k$, a response of the superconductor bulk sub-magnets to a change of the charger current $I_{ch}$ is calculated, taking into account at least a geometry of the charger magnet, a geometry of the superconductor bulk magnet, a background magnetic flux density B generated by the electrical charger magnet, and a critical current density $j_c(B, T_h(k))$ of the superconductor bulk sub-magnets at their applicable temperature $T_h(k)$ determined in step b) for the respective state $st_k$,

d) a charger current step pattern $\underline{c}=(c_k: k=1...N)$ is calculated, with current step increment $c_k:=[I_{ch}(\text{after current step in state } st_k) - I_{ch}(\text{before current step in state } st_k)]^*(-1)$, with the current step increment $c_k$ of the charger current step pattern c to be applied in respective state $st_k$ of the superconductor bulk magnet such that the target persistent current pattern $\underline{i}^{target}=(i_n^{target}: n=1...N)$ in the superconductor bulk sub-magnets would result, based on the responses calculated in step c),

and that the superconductor magnet system is subjected to the field cooling process, applying the temporal sequence of cooling steps $cs_k$ chosen in step a) and applying the charger current step pattern c calculated in step d), thus establishing the target persistent current pattern $\underline{i}^{target}=(i_n^{target}: n=1...N)$ in the superconductor bulk magnet.

The present invention suggests to do the field cooling procedure with a temporal sequence of N cooling steps

$cs_k$ (with k=1...N), in the course of which all N superconductor sub-magnets are cooled below their respective critical temperature $T_c$ (i.e. become superconductive), one after the other. Each time another bulk superconductor sub-magnet has been cooled below its $T_c$, i.e. after cooling step $cs_k$ has been done and state $st_k$ has been achieved, a current step increment $c_k$ is applied, i.e. a change of the charger current $I_{ch}$ occurs, which will induce some persistent current in each bulk sub-magnet already below its $T_c$. After the last current step increment $c_N$, with the individual current step increments $c_k$ of the charger current step pattern c having been chosen properly, the target persistent current pattern $\underline{i}^{target}$ is achieved in the bulk sub-magnets.

In order to find the proper charger current step pattern c with the applied sequence of cooling steps $cs_k$, an advance calculation is applied. The advance calculation calculates (determines) the response or reaction of the superconductor bulk magnet in each of the N (temperature) states $st_k$ (with k=1...N) on changes of the charger current $I_{ch}$, i.e. the sign and strength of an (additional) induced persistent current relative to said change of the charger current $I_{ch}$ in each bulk sub-magnet (wherein in general, only bulk sub-magnets below their $T_c$ will retain a significant persistent current). Note that it is not required to assume a particular amplitude of change of charger current $I_{ch}$ for this purpose (although this can be done for higher accuracy, see below). It should be noted here that for calculating the reaction in state $st_k$, it is important to know in particular the geometry of the structures of the superconductor bulk magnet and their (temperature and magnetic field dependent) conductivity and current carrying capacity in the respective state $st_k$; note here that superconductive structures may exhibit shielding effects on other structures.

Software is publicly available that can simulate the behavior (in particular electric currents) of an L-R network forward in time, which can be used for calculating the reaction of a superconductor magnet system as described above. An example of such a software is "LTspice", mentioned above.

When (at least in good approximation) knowing said reaction for each state $st_k$, it is possible to calculate (determine) the proper charger current step pattern c for obtaining the desired target persistent current pattern $\underline{i}^{target}$.

Generally speaking, the charger current step pattern c can be calculated "from back to front", starting with the target current $i_n^{target}$ with n=N of the last cooled bulk sub-magnet that is directly set with the last current step increment $c_k$ with k=N only. This goes along with an (arbitrary but known) persistent current contribution in the second to last cooled bulk sub-magnet N-1. Then the target current $i_n^{target}$ with n=N-1 of the persistent current of the second to last cooled bulk sub-magnet can be set by choosing the second to last current step increment $c_k$ with k=N-1 such that together with the contribution of the last current step increment, the desired target current of the second last cooled sub-magnet results. Analogously, all further (earlier) currents step increments can be calculated until the first cooled bulk-sub-magnet has been set. So as long as each next cooled sub-magnet in the chosen thermal sequence has a non-zero response to a change of the charger current (i.e. is not shielded by the already cooled sub-magnets), a solution can be found. However note that the current step pattern c can also be calculated more directly, such as by matrix inversion (see below).

Once the advance calculation has been done, the calculated (determined) charger current step pattern c can be applied in practice with the sequence of cooling steps $cs_k$ chosen, resulting (in good approximation) in the desired target persistent current pattern $\underline{i}^{target}$. The target persistent current pattern is typically chosen to achieve (or, rather to prepare achieving) a particular high homogeneity of a magnetic field profile of the (completely) charged superconductor bulk magnet. Note that for the latter purpose, typically the target persistent current pattern $\underline{i}^{target}$ is superimposed with a main persistent current pattern h, resulting from a subsequently applied main field cooling step which captures all superconductor bulk sub-magnets, and during which the entire superconductor bulk magnet is superconducting (see below).

In the course of the inventive procedure, generally arbitrary target persistent currents $i_n^{target}$, with n=1...N can be set for an arbitrary number N of bulk sub-magnets, and accordingly generally all kinds of inhomogeneities, including strong and complex inhomogeneities (such as gradients of third, fourth or even higher order), can be compensated for. In particular, by means of the invention, trial and error numerical approaches can be replaced with purposeful calculation, arriving reliably, fast and with high accuracy at suitable charger current step patterns c for obtaining the desired target persistent current pattern $\underline{i}^{target}$. Note that typically, N≥6, preferably N≥8, most preferably N≥10.

The superconductor bulk magnet or the respective bulk sub-magnets are in general made from a high temperature superconductor material, for example of ReBCO type (Re: rare earth element, in particular Eu, Y or Gd) or BSCCO type or of MgB2 type or of pnictide type (compare WO 2016/161336 A1), with a critical temperature $T_c > 30$ K, often $T_c > 40$ K, and preferably $T_c > 77$ K.

The superconductor bulk magnet is substantially of cylindrical (cylinder jacket) shape and has a central (axial) bore, also called superconductor bore; it comprises a plurality of axially stacked and/or radially nested bulk sub-magnets.

The bulk sub-magnets are generally of closed ring shape, to allow for a persistent circular electrical current each. The currents in the bulk sub-magnets cause a magnetic field substantially along the axis of the central bore ("z-axis"). The bulk sub-magnets may be of "classic type" each, i.e. a one piece ring grown from a melt. Alternatively, the bulk sub-magnets may each comprise a multitude of axial layers and/or radial layers, and may in particular be made of a multitude of stacked ring elements and/or may comprise a circumferential superconductor coating on a tube type carrier body or bodies.

In general, an azimuthally symmetric setup of the superconductor bulk magnet is assumed for the present invention.

*Preferred variants of the invention*

A preferred variant of the inventive method provides

that in step c), for calculating the responses, a test charger current step pattern $\underline{c}^{test}=(c^{test}_k: k=1...N)$ of test current step increments $c^{test}_k$ of a test charger current $I^{test}_{ch}$ is chosen, with $c^{test}_k := [I^{test}_{ch}$(after current step in state $st_k$) - $I^{test}_{ch}$ (before current step in state $st_k$)]*(-1), wherein persistent currents accumulating in the superconductor bulk sub-magnets as a result of the subsequent application of the test current step increments $c^{test}_k$ in the states $st_k$ are calculated,
and that for each test current step increment $c^{test}_k$ a change $cp_{k,n}$ of persistent current in each superconductor bulk sub-magnet n=1...N in state $st_k$ is calculated, and a response $M_{k,n}$ of superconductor bulk sub-magnet n in state $st_k$ is determined with $M_{k,n}=cp_{k,n}/c^{test}_k$.

Depending on the model assumptions for determining the response, with specifying a test charger current step pattern, the behavior of each superconductor bulk sub-magnet and more specifically the response can be calculated (determined) more accurately. If the test charger current step pattern is close to the finally applied charger current step pattern, for example using an iterative procedure, the target persistent current pattern can be set more accurately using the inventive charging method. By means of $M_{k,n}$, the response of the superconductor bulk magnet can be described in a simple and compact way.

The persistent currents obtained after a particular current step increment $c^{test}_k$ in state $st_k$ may be noted $\underline{i}^{test}(k)=(i_n^{test}(k): n=1...N)$; if the persistent currents are monitored as a function of time t, they can also be noted as $\underline{i}^{test}(t)=(i_n^{test}(t): n=1...N)$, with time t; note that the top index "test" is often omitted for simplicity here.

Note that the persistent currents or the respective changes $cp_{k,n}$ can be fully calculated for each superconductor bulk sub-magnet, including "warm" superconductor bulk sub-magnets above their critical temperature $T_c$, or in the course of the calculation the persistent currents or the respective changes $cp_{k,n}$ can be assumed as "zero" for "warm" superconductor bulk sub-magnets in good approximation.

It should also be noted that here the test current step increments $c^{test}_k$ are defined with a factor (-1) such that a reduction of test charger current, which generally leads to a positive induced persistent current, has a positive sign.

In an advantageous further development of the above variant, a response matrix $\mathbf{M}$ is calculated, with $\mathbf{M}=(M_{k,n}: k=1...N$ and n=1...N), and in step d), for calculating the charger current step pattern $\underline{c}$ for the target persistent current pattern $\underline{i}^{target}$, the linear equation system $\underline{i}^{target}=\mathbf{M}*\underline{c}$ is solved for $\underline{c}$. In this way, the charger current step pattern $\underline{c}$ can be determined in a simple way. Note that the linear equation system may alternatively be solved, for example, by back-substitution.

Advantageously, in step d), for calculating the charger current step pattern c for the target persistent current pattern $\underline{i}^{target}$, an inverse matrix $\mathbf{Z} := inv(\mathbf{M})$ is calculated, and c is determined with $\underline{c}=\mathbf{Z}*\underline{i}^{target}$. This is particularly simple to do.

Particularly preferred is a further development, providing that in step c) a first model is applied which includes

- dividing each superconductor bulk sub-magnet into a plurality of radially nested and axially stacked sheets, and
- calculating sheet persistent currents accumulating in the sheets as a result of the subsequent application of the test current step increments $c^{test}_k$ of the test charger current step pattern $\underline{c}^{test}$,

and further that a second model is applied which includes

- for each superconductor bulk sub-magnet n after application of each test current step increment $c^{test}_k$, summing the sheet persistent currents of all sheets belonging to the respective superconductor bulk sub-magnet n into a summed persistent current, and determining the changes of persistent current $cp_{k,n}$ from the summed persistent currents. By using the first model, the behavior of the superconductor bulk magnet (and the electrical charger magnet) can be reproduced more accurately. Typically, each bulk sub-magnet is divided into at least four radial sheet layers and at least five axial sheet layers, and the total number D of sheets of the superconductor bulk magnet (also called "nodes" of the first model) is much larger than the number N of bulk sub-magnets, such as $D \geq 20*N$, or even $D \geq 50*N$. By further applying the second model, the calculation effort for determining the charger current step pattern c is kept small. Note that applying the first and second model results in the response or the Matrix $\mathbf{M}$, respectively, being a function of the chosen test charger current step pattern $\underline{c}^{test}$.

A preferred further development provides

that the method comprises a plurality of iterations, comprising

- a first iteration including step a), step b), step c) and step d),
- optionally one or more intermediate iterations including step c) and step d), and
- a final iteration including step c) and optionally step d),

that in the first iteration, in step c), the test charger current step pattern $\underline{c}^{test}$ is chosen arbitrarily, in particular with equal test current step increments $c^{test}_k$, that in one or more subsequent iterations, the charger current step pattern $\underline{c}$ resulting from step d) of the previous iteration is used as test charger current step pattern $\underline{c}^{test}$ in step c) of the current iteration,

and that when the superconductor magnet system is subjected to the field cooling process, the charger current step pattern $\underline{c}$ calculated in step d) of a last iteration that included step d) is applied. By applying the iterations, the test charger current step pattern can be brought closer to the final charger current step pattern c to be applied during the actual field cooling, and the inventive calculation of the charger current step pattern $\underline{c}$ for achieving the target persistent current pattern $\underline{i}^{target}$ becomes more accurate. Note that the number of the iteration is sometimes indicated with a top index a, typically starting with a=0 for the first iteration (= repetition number 0), a=1 for the second iteration (repetition number 1), and so on, in particular for the response matrix $\mathbf{M}$ and its inverse $\mathbf{Z}$, e.g. with $\mathbf{M}^0$, $\mathbf{Z}^0$, $\mathbf{M}^1$, $\mathbf{Z}^1$, and so on.

Preferably, in the latter further development, it is provided that

$\alpha$) the final iteration includes a step d), and if a difference between a charger current step pattern $\underline{c}$ of the current iteration and a charger current step pattern $\underline{c}$ of the previous iteration is more than a threshold value, then another iteration is performed, else the current iteration is the final iteration and no more iteration is performed, or $\beta$) for each iteration, in step c) a test target persistent current pattern $\underline{i}^{test,target}=(i_n^{test,target}\colon n=1...N)$ in the superconductor bulk sub-magnets is calculated based on the test charger current step pattern $\underline{c}^{test}$ of the current iteration, and if a difference between the test target persistent current pattern $\underline{i}^{test,target}$ of the current iteration and the test target persistent current pattern $\underline{i}^{test,target}$ of the previous iteration is more than a threshold value, then another iteration is performed, else the current iteration is the last iteration and no more iteration is performed, in particular wherein the final iteration does not include a step d), or $\gamma$) for each iteration, in step c) a test target persistent current pattern $\underline{i}^{test,target}=(i_n^{test,target}\colon n=1...N)$ in the superconductor bulk sub-magnets is calculated based on the test charger current step pattern $\underline{c}^{test}$ of the current iteration, and if a difference between the test target persistent current pattern $\underline{i}^{test,target}$ of the current iteration and the target persistent current pattern $\underline{i}^{target}$ is more than a threshold value, then another iteration is performed, else the current iteration is the final iteration and no more iteration is performed, in particular wherein the final iteration does not include a step d). In this way, a desired level of accuracy of the calculation of the charger current step pattern $\underline{c}$ for achieving the desired target persistent current pattern $\underline{i}^{target}$ can be ensured.

A preferred variant of the inventive method provides

that the superconductor bulk magnet is chosen with at least one stack of axially stacked superconductor bulk sub-magnets, thermally linked in a linear sequence via thermal impedances, with an end side superconductor bulk sub-magnet of the stack thermally linked to a cooling stage,

and that in step a) the temporal sequence of cooling steps $cs_k$ is chosen such that in a respective stack, superconductor bulk sub-magnets of the linear sequence closer to the cooling stage are cooled below their critical temperature $T_c$ before superconductor bulk sub-magnets of the linear sequence farther away from the cooling stage. In this way, the cooling steps $cs_k$ can be established with rather simple equipment. In particular, a one-sided (common) cooling stage and a simple linear linkage of the bulk sub-magnets is sufficient for allowing a stepwise cooling of the bulk sub-magnets along the sequence. Note that typically, each bulk sub-magnet is equipped with a heater element and a temperature sensor. However, no individual links (in particular adjustable individual links) of the sub-magnets to the cooling stage are necessary.

Further preferred is a variant providing that the superconductor bulk magnet is chosen with at least two radially nested stacks of axially stacked superconductor bulk sub-magnets,

and that in step a) the temporal sequence of cooling steps $cs_k$ is chosen such that superconductor bulk sub-magnets of a stack radially farther inside are cooled below their critical temperature $T_c$ before superconductor bulk sub-magnets of a stack radially farther outside. In this way, shielding effects of already superconducting bulk sub-magnets with respect to not yet superconducting bulk sub-magnets are minimized, and comparably small current step increments are sufficient to establish a desired target persistent current pattern. Note that preferably, the sub-magnets of one stack are all cooled down before cooling at a next stack begins, with the stacks being cooled down, with the stacks being cooled from inside to outside.

Particularly preferred is a variant providing that in step b), the distributions I(k) of temperatures of the superconductor bulk sub-magnets in the states $st_k$ are determined experimentally for the temporal sequence of cooling steps $cs_k$ chosen in step a), wherein thermal sensors at the superconductor bulk sub-magnets are read out, and wherein control parameters of the cooling system applied for establishing the temporal sequence of cooling steps $cs_k$ are recorded, and that when the superconductor magnet system is subjected to the field cooling process, the temporal sequence of steps $cs_k$ of step a) is applied using the same control parameters of the cooling system. Determining the distributions T(k) underlying the calculation by measurement leads to realistic and exact temperature values. Further, by applying the same control parameters in the actual field cooling as in the step b), the actual field cooling will, with high accuracy, be matching the assumptions of the calculation, and the target persistent current pattern $\underline{i}^{target}$ can be set with high accuracy.

A highly advantageous variant is characterized in

that after the target persistent current pattern $\underline{i}^{target}=(i_n{}^{target}: n=1...N)$
has been established in the superconductor bulk magnet by the field cooling process, then a main field cooling process is performed,
that during the main field cooling process, all N superconductor bulk sub-magnets are below their critical temperature $T_c$, and the charger current $I_{ch}$ is further varied, in particular reduced to zero, such that the main field cooling process adds a main persistent current pattern $\underline{h}=(h_n: n=1...N)$ to the target persistent current pattern $\underline{i}^{target}=(i_n: n=1...N)$ in the superconductor bulk sub-magnets,
and that the target persistent current pattern $\underline{i}^{target}=(i_n{}^{target}: n=1...N)$ has been chosen such that a magnetic field in a sample volume of the superconductor bulk magnet based on a sum current pattern $\underline{s}=\underline{i}^{target}+\underline{h}$ is more homogeneous than a magnetic field in the sample volume of the superconductor bulk magnet that would result based on the main persistent current pattern $\underline{h}$ alone. In this way, particularly homogeneous magnetic fields can be provided with low apparatus efforts with a superconductor bulk magnet. Note that typically, a magnetic field generated by the main persistent current pattern $\underline{h}$ alone is measured in advance and its inhomogeneities are determined, and then $\underline{i}^{target}$ is determined such that the magnetic field resulting from $\underline{i}^{target}$ alone will compensate for said determined inhomogeneities.

*Inventive superconductor magnet system*

Also within the scope of the present invention is a superconductor magnet system, comprising

-    a superconductor bulk magnet, with the superconductor bulk magnet comprising N superconductor bulk sub-magnets,
-    and a cooling system for the N superconductor bulk sub-magnets,

wherein the superconductor bulk magnet comprises at least one stack of axially stacked superconductor bulk sub-magnets,
wherein the cooling system comprises a common cooling stage for all superconductor bulk sub-magnets of the superconductor bulk magnet,
wherein a first superconductor bulk sub-magnet of the stack located at one end of the stack is thermally linked to the cooling stage only via a non-adjustable first thermal impedance,
wherein the superconductor bulk sub-magnets of the stack are thermally linked to each other in a linear sequence via non-adjustable intermediate thermal impedances,
wherein the superconductor bulk sub-magnets farther away from the cooling stage in the linear sequence than the first superconductor bulk sub-magnet are thermally linked to the cooling stage only through the superconductor bulk sub-magnets and the non-adjustable intermediate thermal impedances closer to the cooling stage in the linear sequence and the non-adjustable first thermal impedance,
characterized in
that the cooling system is adapted to individually set temperatures $T_n$ of the N superconductor bulk sub-magnets, wherein for each superconductor bulk sub-magnet there is a heater element thermally linked to the respective superconductor bulk sub-magnet. This superconductor magnet system is simple in construction and allows a sequential cooling of the bulk sub-magnets within the at least one stack along the linear sequence, what is enough to establish basically arbitrary target persistent current patterns according to the above mentioned inventive method for charging. In particular it is not necessary to allow for arbitrary temperature distributions among the superconductor bulk sub-magnets, what would require relatively high apparatus efforts, such as switchable thermal links. Each stack typically comprises four or more bulk sub-magnets ("bulk rings"), preferably five or more, most preferably ten or more. By individually charging the axially stacked sub-magnets, the magnetic field generated by the superconductor bulk magnet can be shaped as required, in particular for improving homogeneity.

In a preferred embodiment of the inventive superconductor magnet system, for each superconductor bulk sub-magnet, there is a temperature sensor for sensing the respective temperature T of the superconductor bulk sub-magnet. This allows a better control (including monitoring and adjustment) of the temperature distribution within the superconductor magnet system. Typically, heater element and thermal sensor are attached to a metallic ring corseting the respective bulk sub-magnet on its outside.

Advantageous is an embodiment wherein the superconductor bulk magnet comprises at least two radially nested stacks of axially stacked superconductor bulk sub-magnets. By radially nesting stacks of superconductor bulk sub-magnets, higher magnetic field strengths may be achieved, and by charging the bulk sub-magnets in radial sequence differently, the magnetic field generated can be shaped in a desired way, in particular in order to achieve a good homogeneity in a larger sample volume.

*Some examples for the invention*

In an example, there is applied a method for operating an inventive superconductor magnet system as described above, wherein a temporal sequence of cooling steps is applied, wherein in a respective stack, superconductor bulk sub-magnets of the linear sequence closer to the cooling stage are cooled below their critical temperature $T_c$ before superconductor bulk sub-magnets of the linear sequence farther away from the cooling stage,

in particular wherein after each cooling step, a partial charging of those bulk superconductor sub-magnets which are already cooled below their critical temperature $T_c$ is done via field cooling. By operating the superconductor magnet systems in this way, all bulk sub-magnets can be cooled below their critical temperature $T_c$ one after the other, and practically arbitrary target persistent current patterns $\underline{i}^{target}$ can be established with low apparatus effort by stepwise field cooling. The linear sequence of bulk sub-magnets and their non-adjustable intermediate thermal impedances (including the first thermal impedance) establish a thermal connection to the common cooling stage, and by way of the heater elements, cooling can be blocked (counter-acted) where needed. No direct (and then typically adjustable) coupling of the bulk sub-magnets to the common cooling stage is necessary (with the exception of the first bulk sub-magnet, which is directly linked to the cooling stage via the first non-adjustable thermal impedance).

In a preferred variant of the above example, in the method for operating a superconductor bulk magnet, in a state wherein a plurality of superconductor bulk sub-magnets of a stack is to be kept above $T_c$, further referred to as warm plurality, then only the heater element of the superconductor bulk sub-magnet of the warm plurality closest to the cooling stage in the linear sequence is heated, but not the heater elements of the superconductor bulk sub-magnets of the warm plurality farther away from the cooling stage in the linear sequence. The heater element of the superconductor bulk sub-magnet of the warm plurality closest to the cooling stage in the linear sequence can block (counter-act) the cooling effected by the common cooling stage for the entire "warm plurality", and thus keep the warm plurality decoupled from the common cooling stage. In this way, the number of temperature gradients in the superconductor bulk magnet can be minimized, what reduces heat flow and saves cooling power. So this variant is particularly simple to put into practice and highly efficient.

In another example, there is applied a method for operating an inventive superconductor magnet system as described above, wherein the superconductor bulk magnet comprises at least two radially nested stacks of axially stacked superconductor bulk sub-magnets, wherein a temporal sequence of cooling steps is applied, wherein superconductor bulk sub-magnets of a stack radially farther inside are cooled below their critical temperature $T_c$ before superconductor bulk sub-magnets of a stack radially farther outside,

in particular wherein after each cooling step, a partial charging of those superconductor bulk sub-magnets which are already cooled below their critical temperature $T_c$ is done via field cooling. By this approach, radial shielding effects of already cold bulk sub-magnets (below their $T_c$) with respect to not yet cold bulk sub-magnets are minimized, and generally low current step increments are sufficient to establish a desired target persistent current pattern.

Further it should be noted that an example may include the use of an inventive superconductor magnet system as described above in an inventive method as described above. The inventive superconductor magnet system is simple and inexpensive in construction and can be charged purposefully and easily to achieve practically arbitrary target persistent current patterns or corresponding magnetic fields.

*Inventive use*

Finally, within the scope of the present invention is the use of an inventive superconductor magnet system as described above, or of a superconductor magnet system charged in an inventive method as described above, in a nuclear magnetic resonance (=NMR) measurement. By means of the invention, highly homogeneous magnetic fields and/or extended sample volumes of high homogeneity may be obtained, which improves the quality of the chemical information on the sample obtained by NMR.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

Drawing

The invention is shown in the drawing.

Fig. 1a    shows a schematic cross-sectional view of a superconductor magnet system for the invention by way of example;

Fig. 1b    shows the superconductor magnet system of Fig. 1a, schematically illustrating the thermal properties;

Fig. 2    shows the superconductor magnet system of Fig. 1a, illustrating dimensions of the sub-magnets to scale;

Fig. 3    illustrates the test charger current and the trapped persistent currents as a function of time in a first iteration of advance calculation for the invention by way of example;

Fig. 4    illustrates the response matrix **M** and its inverse Z for said first iteration of Fig. 3;

Fig. 5a    illustrates the inventive method with iterations in the chosen example, in a variant wherein iteration stop is triggered via the charger current step pattern $\underline{c}$ calculated in each iteration;

Fig. 5b    illustrates the inventive method with iterations in the chosen example, in a variant wherein iteration stop is triggered via a test target persistent current pattern $\underline{i}^{test,target}$ calculated in each iteration;

Fig. 6    illustrates a heating power pattern for the chosen example of the inventive method;

Fig. 7    illustrates a temperature distribution for the chosen example of the inventive method;

Fig. 8    illustrates the temporal sequence for the chosen example of the inventive method, with on the left the list of bulk sub-magnets with abbreviation explanation and sequence index number, and on the right the position of the bulk sub-magnets in the superconductor bulk magnet with their abbreviations;

Fig. 9    illustrates the test charger current and the trapped persistent currents as a function of time in a second iteration (a=1) of advance calculation for the chosen example of the invention;

Fig.10    illustrates the response matrix **M** and its inverse **Z** for said second iteration of Fig. 9

Fig. 11    illustrates the test charger current and the trapped persistent currents as a function of time in a third iteration (a=2) of advance calculation for the chosen example of the invention;

Fig. 12    shows schematically for the example chosen the on axis component of magnetic fields, resulting for the superconductor bulk sub-magnet with a main field cooling step only, and with a preparatory and a main field cooling step according to the invention;

Fig. 13a    shows a schematic cross-section along the z axis of a charger arrangement for the chosen example of the invention;

Fig. 13b    schematically illustrates the heaters and thermometers of Fig. 13a.

## 1. Introduction

Post-published European patent application 20 174 683.1 provides several methods for achieving more homogeneous magnetic fields for field cooled bulk superconducting magnets. Part of the methods is based on a thermal control system that allows to dial in offset currents in a preparatory step at intermediate temperatures before the main field cooling step is performed. These preparatory offset currents are tailored so as to provide a field contribution that leads to a substantially more homogeneous field when added to the trapped field from the main field cooling step.

Those methods are applicable to a single pile of axially stacked bulk rings, and they are used for a relatively modest number of independent currents (typically 2-3), addressing essentially linear and quadratic gradients. The precise amplitude of these rather simple cases need to be "smart-guessed" using highly iterative trial-and-error numerical approaches.

The present invention introduces a method that can cope with more general cases and which, in particular, provides a simple and fast converging numerical way to deal with complex structures like nested bulk rings and a comparatively large number of independent currents/bulk rings. The invention allows for both, a substantially broader scope of realistically addressable (on-axis) gradients, and a simpler and hence more cost-effective hardware. Hardware (apparatus) requirements can be reduced by an improved way to dial the desired target currents into a broad class of systems.

The inventive method is based on post-published European patent application 20 174 683.1, where the preparatory step was embedded between a charger ramp-up before and a field cooling after the preparatory step, and in some cases also a post-optimization step. In this description, those steps will not be repeated; rather it is described here what happens at "high-field", after ramping up the charger current and before ramping down the charger current again (main field cooling step). The described method can be understood as an improved version of the preparatory steps in methods A-G in post-published European patent application 20 174 683.1. The content of European patent application 20 174 683.1 is herewith incorporated by reference.

The method of the present invention is labelled here "N step N bulk thermal shim" as it is understood to be the general case with N degrees of freedom. If there are N superconductor bulk sub-magnets (or "bulk rings") in the stacks (e.g. N=10 for the chosen example system with two nested stacks of five bulk rings each) then there are N independent currents flowing through those rings, one current in every bulk ring. Starting with all rings at $T>T_c$, then all currents are zero at that point. Next, one bulk ring is brought to substantially below $T_c$ (so that it can carry some current superconductingly), while all the others remain above $T_c$, and ramp the charger magnet a little (say e.g. -50 mA). The one superconducting bulk ring will pick up some induced current as it couples to the charger. All others also couple, but their currents decay almost instantaneously as they have a high (ohmic) resistivity. So only the cold, superconducting bulk ring will "trap" his current persistently. Next, a second ring is cooled to substantially below $T_c$, while keeping the first ring cold, and all others remain above $T_c$. Again, the charger current is ramped a little bit. Again, all currents in warm bulk rings decay quickly. The two superconducting rings will both pick up some induced current upon this step, so that after this second charger ramp, we have two rings that carry persistent current. Note that the first ring will carry the sum of the two currents that it had picked up in the two steps. This procedure is continued with all of the remaining N-2 bulk rings, so that in the end, all N bulk rings will carry some (non-zero) current. A number of N charger ramp steps (corresponding to current step increments $c_k$) have been performed on a set of N bulk rings, ending up with N persistent currents in the bulk rings.

To illustrate this procedure, the method is described based on an example with N=10 in the next chapters; however it should be noted that the invention has also been successfully tested with N=15 on three nested stacks. The invention may be used with practically arbitrary numbers of bulk rings in arbitrary geometry, in particular with one or more radially nested stacks of axially stacked bulk rings. The numerical simulation no longer is the limiting entity, real-world production of such complex (high-N) structures is. Further it should be noted that the present invention is in no way limited by the example discussed below.

The invention suggests a method to numerically determine the charger ramp step amplitudes (or current step increments $c_k$) for a given "charging setup" (including bulk ring geometry and superconductor material) and "activation sequence" (i.e. temporal sequence of cooling steps), so as to produce a given target persistent current pattern in the set of bulk rings. This target persistent current pattern can be used to counter-act potential imperfections in trapped fields in analogy to post-published European patent application 20 174 683.1. Further, the invention provides an easy-to-manufacture hardware setup to prove effectivity and efficiency of the method and show a practical application.

## 2. Theory

### 2.1. The hardware model (superconductor part, N=10)

The method can be applied to nested stacks of bulk rings as shown for the chosen example of N=10 with two stacks of five rings each.

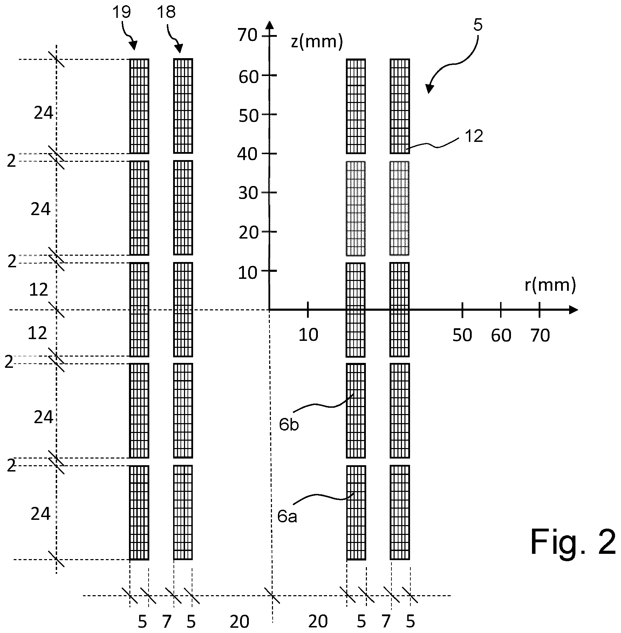

In **Fig. 2,** which illustrates schematically in section along the z axis the superconductor bulk magnet 5 on which the example is based, there are shown a radially inner stack 18 and a radially outer stack 19 of superconductor bulk sub-magnets (or "bulk rings"), with only sub-magnets 6a, 6b shown with a reference sign for simplification here. The illustrated example also includes the dimensioning (in mm, explicitly shown at the axes) of the bulk sub-magnets, which has to be known for simulating the charging behavior of the superconductor bulk sub-magnet 5 (see later); however note that the invention is in no way limited to the shown dimensioning of the chosen example.

It is not required to have bulk rings of the same height, nor is it required to have stacks of equal radial thickness. The method has been tested for up to three nested stacks but it is obvious that there is no theoretical limit to the method. The various stacks can also have different overall axial extensions if desired.

For the sake of simplicity, however, it is stayed with this configuration for the remainder of the description. A parameters space with ten degrees of freedom is sufficiently large to make it plausible that the solution cannot be "smart-guessed" but needs a guided iterative process.

2.2. The two numerical models

The method, as illustrated in this example, is based on two models, one fully numerical, and one "semi-analytical". The numerical model ("first model") is a representation of the bulk ring system in a simulation software like e.g. LT-spice (but many finite-element tools may be used for that purpose) that contains hundreds if not thousands of nodes. It is used to simulate an R-L-network forward-in-time, where every bulk ring is divided into many small azimuthal current sheets, with resistance

$$\underline{R}(t) = \underline{R}(T(t)) = (R_d(T_d): d=1...D)$$

and an inductance and an inductive coupling with all other such elementary rings which together form the inductance matrix **L**. In the chosen example with N=10 bulk rings, a model with D = 550 nodes is used, i.e. 10 bulks, divided into 5 radial times 11 axial segments each. Fig. 2 illustrates the sheets here 5x11 sheets 12 for the bulk sub-magnets 6a, 6b.

Note here that this leads to a dimension 1100 DAE (differential algebraic equation). The simulation iterates a thermal model, updated at fixed time steps along with the solving of the DAE system. The DAE is solved with energy conserving algorithms such as a BDForder 4 multistep method, while the thermal part is simplified with a lumped finite differences scheme.

Such R-L-network simulation code readily exists even free of charge (e.g. LTspice). It can be used to calculate the induced currents for every node, and then sum over the nodes within one bulk ring:

$$\underline{i}(t) = (i_n(t): n=1...N) \, ,$$

where

$i_n(t)$ is the summed current over all nodes within bulk ring n

We can therefore deduce the persistent current in each ring as a function of the "driving" parameters $\underline{R}(T(t))$, **L**(t), and $I_{ch}(t)$, where $\underline{R}$ is the resistance vector, **L** is the inductance matrix, and $I_{ch}(t)$ is the charger current. $\underline{R}$ is a D-dimensional vector, **L** is a (DxD) matrix, $\underline{i}$ is an N-dimensional vector, $I_{ch}$ is a scalar.

The "second model" is much simpler/smaller. The number of nodes equals the number of bulk rings, N. Every bulk ring is simply represented by its overall current and temperature. The model hence has two types of variables to describe the system state as a function of time t:

- Global variable: charger current, here referred to as test charger current $I^{test}_{ch}$, since it is applied during advance calculation/simulation,
- Local variables for every bulk ring: temperature $T_n$ and its total (test) persistent current $i_n$, also noted sometimes as $i^{test}_n$

The method will now iterate back and forth between the two models: for a given set of "driving parameters" $I^{test}_{ch}(t)$, $T_n(t)$, the first model is used to calculate the "forward-response" $\underline{i}(t)$, then the "response" $\underline{i}(t)$ will be used to iterate the driving parameters (or rather $I^{test}_{ch}(t)$ for the next iteration represented by a charger current step pattern $\underline{c}^{test}$ with a number of current step increments $c^{test}_k$, with k=1...N) of the next iteration.

The loop is repeated until, in the variant presented here, predefined target currents $\underline{i}^{target}$ are met by $\underline{i}(t)$ at the end of an iteration (i.e. by $\underline{i}^{test,target}$, see below) to a sufficient degree of accuracy.

Convergence was observed after a total of three calculations/iterations (initial plus two iterations) for the above example to an accuracy in the ppm range for the set of arbitrarily chosen target currents.

2.3. Activation and Activation sequence

In the first chapter it was stated that "one bulk after the other is activated". This should be discussed a little deeper for two reasons:

First, we need to understand what temperature is required for a bulk ring to be "(de-)activated", and second, we need to define the notion of the activation sequence, i.e. the order in which the bulk rings are brought to the superconducting state. There are good ones, bad ones, and one which is quite useful.

Every superconducting material is characterized by the critical current density $j_c(B, T)$, i.e. the capability of carrying a given persistent current density $j_c$ in a given background field B at a given temperature T. Universally, the higher B and/or T, the lower $j_c$, until, at a critical field $B_c$ or at a critical temperature, $T_c$, the critical current density $j_c$ vanishes. In the numerical model there has been used an HTS conductor (GdBCO), for which $B_c$ is very high (about 100 Tesla), and hence far away for any application (with single-digit Tesla fields).

The critical temperature $T_c$ in the model background field of around 6 Tesla of GdBCO is slightly below 80 Kelvin. 6 Tesla was also chosen as the background field in post published European patent application 20 174 683.1 framework, so this value is used again for ease of comparison. The initial temperature level to prepare the bulk rings in the "deactivated" state was chosen to be 80 Kelvin in this example.

Below 80 Kelvin, the bulks become superconducting. At $T_c$ the critical current is zero by definition, increasing gradually as temperature is lowered. At about 74 Kelvin/6 Tesla, $j_c$ is sufficiently high so that the bulk rings can carry around 800 A persistently with no resistive losses. This is somewhat higher than the level of preparatory currents aimed at, and so 74 Kelvin was chosen as the "activation" threshold temperature. The method works if all activated bulk rings are at 74 Kelvin or below.

**The activation sequence** is the order in which the bulk rings are "activated". From the N bulk rings, one is picked that is cooled first to below the threshold of 74 Kelvin, then the charger is ramped, then the second bulk ring is cooled to below 74 Kelvin, then the charger is ramped, and so on. Once a bulk ring is below the threshold, it is not allowed to be warmed above the threshold ever again during the procedure.

Starting with N bulk rings, there are N possibilities for the first pick, then (N-1), (N-2) etc. In total there are (N!) possibilities for the activation sequence. In the case of N=10, that is around 3.5 million - and not all of them are equally useful to produce a given target current pattern $\underline{i}^{target}$.

To see this, consider the following example:

Assume an activation sequence where in the first five steps, the bulk rings of the outer stacks are activated and hence superconducting until the end of the sequence. In step six and seven the uppermost and lowermost bulk ring of the inner stack are activated. The three bulk rings in the middle of the inner stack are now completely enclosed by activated superconducting bulks. It is then nearly impossible to induce any substantial currents in these rings as they are shielded from the charger by the surrounding activated bulk rings. Their response is very close to zero, and we will not be able to dial in the target current and the method fails.

So, any "good" sequence should first activate bulks from the inner stack, and only then activate the ones from the outer stack. The number of choices goes from 10! > 3 million to $(5!)^2 = 14400$.

It is advantageous to have a low number of "activation interfaces" (an activated bulk ring next to a still-inactive one) within one stack, as they come with the penalty of a thermal gradient, and across every thermal gradient there will be a heat flow. Each heat flow is associated with heating and cooling, and the number of interfaces is hence dictating the total cooling power requirement for the hardware.

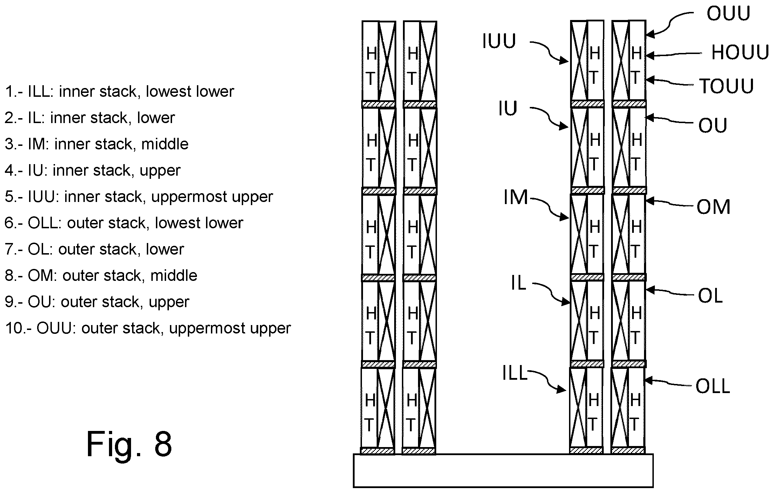

The chosen activation sequence here is (ILL, IL, IM, IU, IUU, OLL, OL, OM, OU, OUU), where the first letter denotes the stack (Inner I / Outer O), and the remaining letters define the axial position of the bulk rings from lowermost to uppermost (Lowermost LL, second lowest L middle M second uppermost U, uppermost UU), see also Fig. 8 below.

2.4. Initial response matrix $M^0$, inverse $Z^0$, and current mapping

In this paragraph it is shown how to close the feedback loop.

The first, fine-granular model is used to calculate the system response (represented by persistent currents) $\underline{i}(t)$ to the driving parameters $\underline{T}(t)$, $I^{test}_{ch}(t)$. We recall the definitions of

$$\underline{i}(t) = (i_n(t) : n = 1...N)$$

as the (test) persistent currents in the bulk rings, n labelling the bulk rings, while

$$\underline{T} = (T_n(t): n=1...N)$$

denotes the temperatures of the bulk rings.

$I^{test}_{ch}$ is the (test) charger current.

The idea is simple: Within the simulation, we apply a "trial" (or test) sequence $\underline{c}^{test}$ of e. g. equidistant charger current steps of a test charger current $I^{test}_{ch}$, say -50 mA per step, while we apply the chosen (thermal) activation sequence to the bulk rings. The test charger current increments are typically indexed with a sequence index k, with k=1...N, corresponding to $c^{test}_k$.

The system response after every charger ramping step as simulated by the first model is recorded into a "response matrix" $\mathbf{M^0}$ (details below), which can be used to determine a test target persistent current pattern $\underline{i}^{test,target}$ = $(i_n: n = 1...N)$ after all N steps, resulting from the applied test charger current step pattern

$$\underline{c}^{test} = (c^{test}_k : k = 1..N), \text{ where } c^{test}_k := [I^{test}_{CH} \text{ (after step k) } - I^{test}_{CH} \text{ (before step k)]}*(-1).$$

This can be written in a compact form:

$$\underline{i}^{test,target} = \mathbf{M^0}\ \underline{c}^{test}$$

To determine the required charger step pattern c for an arbitrary target persistent current pattern $\underline{i}^{target}$, the inverse matrix $\mathbf{Z^0} := inv(\mathbf{M^0})$ is calculated, and the "target" charger current step pattern c can be calculated with

$$\underline{c} = \mathbf{Z^0}\ \underline{i}^{target}$$

Note: For an upper triangular matrix $\mathbf{M}$ it is not strictly required to calculate the inverse matrix $\mathbf{Z}$ in order to solve for the charger current vector $\underline{c}$, but the corresponding system of linear equations can be solved directly, e.g. by back-substitution. The approach using the inverse matrix here is more intuitive so it is used here for better understanding, whereas in practice, the faster and numerically simpler back-substitution is often used.

Rerunning the first model in a next iteration with the same activation sequence and using the above charger current step pattern $\underline{c}$ as new test charger current step pattern $\underline{c}^{test}$ leads to a next charger current step pattern $\underline{c}$ in the bulk rings that is quite close to the target persistent current pattern. Small deviations, typically in the single-digit percent range, stem from the simplifications in the second model in which only overall total currents in the rings are considered, rather than distributed values. Going from a D-dimensional model (example: D=550) to an N-dimensional model (example: N=10) requires neglection of detail information which leads to some deviations.

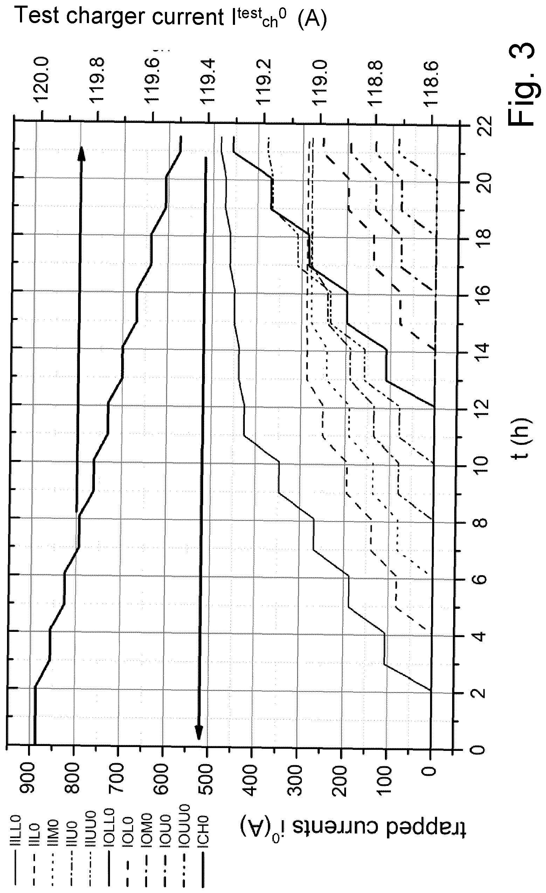

The execution of the above scheme on the model system with N=10 and an initial charger step pattern of 120 A starting value and current steps of -50 mA with every step is illustrated in **Fig. 3.** It shows the induced persistent currents i in the bulk rings and the test charger current $I^{test}_{ch}$ as a function of time t for the first iteration with iteration index a=0. Charger steps (also called test charger step increments $c^{test}_k$) are performed every two hours starting at time t=2h, wherein each charger step takes about 1 hour. Note here that each charger step is preceded by a cooling step $cs_k$ during which a next bulk ring has been brought below $T_c$ in order to prepare it for taking over a persistent current.

In Fig. 3, all bulk currents i are at zero amps initially. After step 1 (at about t=3 h), the first bulk ring picks up about 105 A, and so the response matrix element (which is normalized by the amplitude of the current step) will be about 105 A / 0.05 A = 2100. All other bulk rings still have zero amps as they are still inactive. After step 2 (at about t=5h), the first bulk ring has 185 A, the second one 80 A, and the matrix elements must hence be about 1600 in both cases (both have trapped 80 A from a 50 mA charger step), while all other elements are still zero.

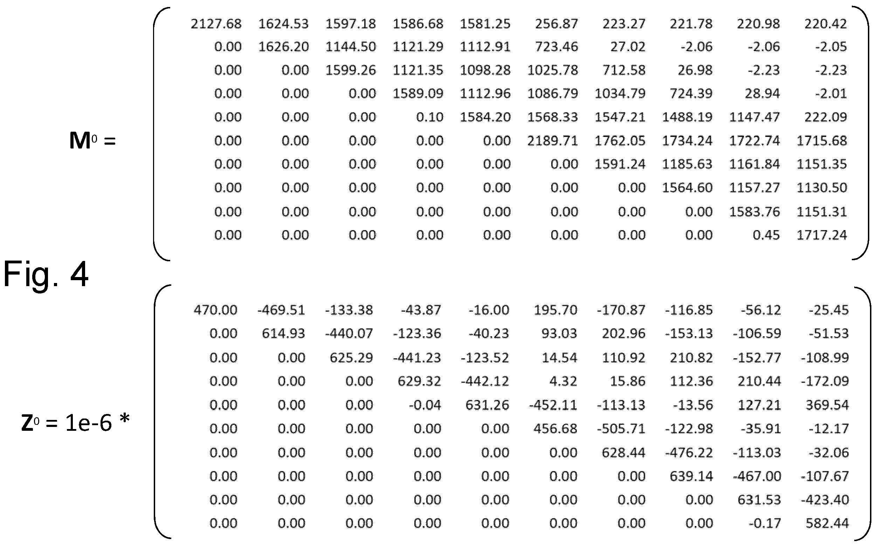

Constructing the matrix in this manner leads to the response matrix $\mathbf{M^0}$ shown in **Fig. 4** in its top part.

This matrix can be exported directly from the first model using the relaxed values at the appropriate points in time after the subsequent charger ramps.

In the next step, the matrix is inverted numerically, resulting in Matrix $Z^0$ shown in Fig. 4, lower part. The existence of the inverse is closely linked to the avoidance of "shielded activation sequences" as described earlier.

When the inverse $\mathbf{Z^0} := inv(\mathbf{M^0})$ has been calculated, the required charger current pattern $\underline{c}$ for a given target current pattern $\underline{i}^{target}$ is determined using the the above mentioned formula $\underline{c} = \mathbf{Z^0}\ \underline{i}^{target}$, and the resulting pattern $\underline{c}$ is fed back into the first model for the next iteration.

Although the result of this procedure (up to this point) is not far from the desired outcome, there are still some deviations. They have been found to be within a low single-digit percent value of the overall (correction) target current.
The next paragraph describes how to bring them to virtually zero.

2.5. <u>Refinement: iterating the response matrix</u>

In the previous paragraph we have shown how to calculate the initial response matrix $\mathbf{M^0}$ of the system and how to deduce a "target" charger current step pattern $\underline{c}$ that leads to an approximate trapping of the desired current pattern $\underline{i}^{target}$ in the superconductor magnet system.
In this paragraph construction of a (quickly converging) iterative method to minimize those deviations is presented.

*The deviations*

The deviations between the target persistent current pattern $\underline{i}^{target}$ and a simulated (trapped) persistent current pattern $\underline{i}^{test,target}$ (which would result according to the first and second model from the application of the charger current step pattern $\underline{c}$ found in the previous iteration or arbitrarily chosen initially) stem from the difference in complexity and hence accuracy of the first and second model. In order to be able to close the feedback loop using the response matrix, the dimensionality was limited to the number N of physically addressable degrees of freedom (the charger steps) in the second model. Hence the induced currents within one bulk ring are represented by one single (total) value rather than a grid of elementary currents. The bulk ring (sub-magnet) is hence treated as an equivalent ring element, which neglects inhomogeneities and spatial current gradients within the bulk ring. The response matrix serves as an approximation to numerically determine these equivalent elements.
The initial sampling run is done on an arbitrarily chosen sequence of charger steps, e.g. ramping the charger down by the same amount of current interval on every step (in the example above 50 mA). This sampling pattern is usually very different from the actual required pattern that is needed for dialing in the target currents.

*The iterative method*

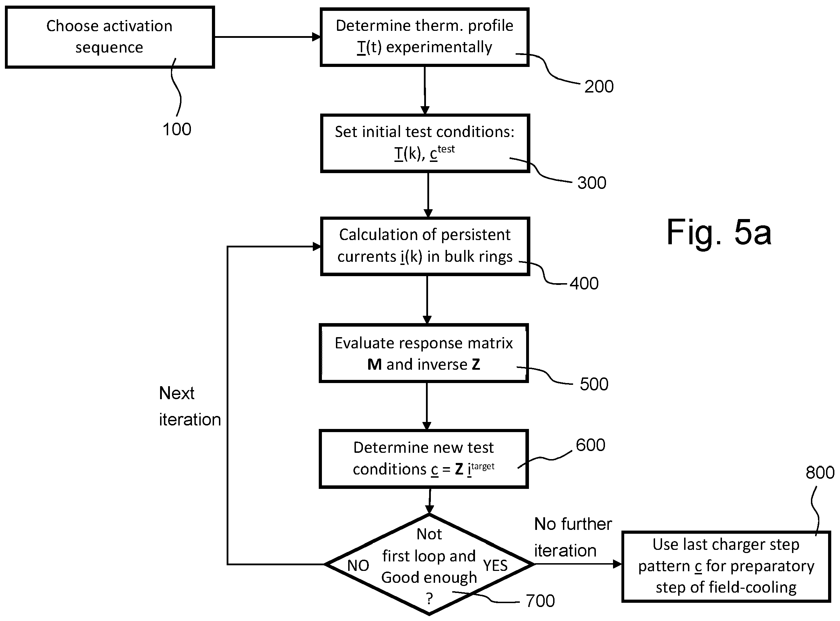

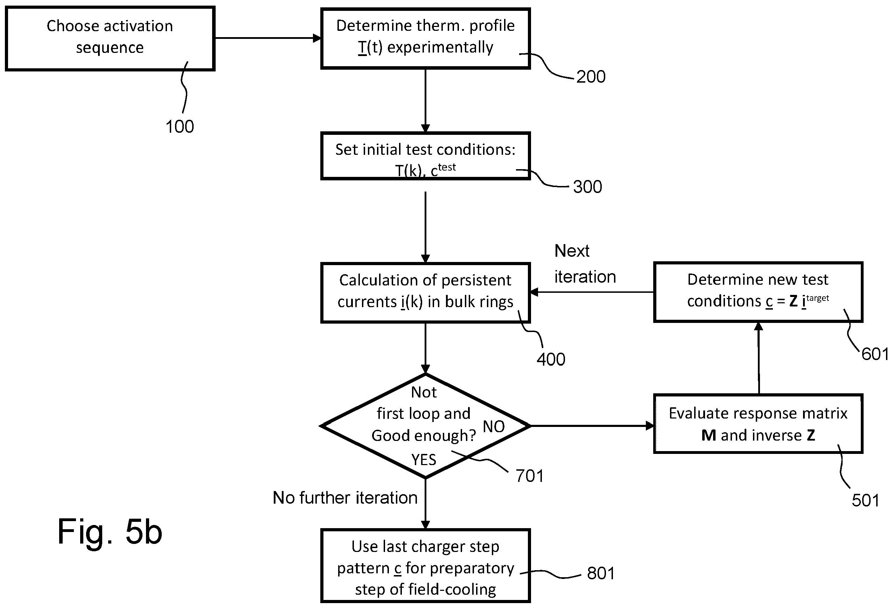

The observed deviation between response currents (target minus trapped) *"scales with the deviations in driving currents at the sampling points".* The determined response matrix becomes more and more accurate as it is sampled closer to the actual charging pattern.
This scaling behavior can be exploited to construct a quickly converging iteration scheme.
Here this is called the "determination of the effective response matrix at the relevant working point".
The iterative method is hence a repeated loop of calculations of the response matrix $\mathbf{M^a}$, its inverse $\mathbf{Z^a}$ and the charger current vector (or charger current step pattern) $\underline{c}^a$ (a being the iteration index) using the procedure developed in the previous paragraph, with the incremental improvement that the response matrix $\mathbf{M^a}$ is recalculated during the respective charger step with the improved amplitude (test charger current step increment) $c^{test}{}_k{}^a$, corresponding to $c_k{}^{a-1}$ of the previous iteration.
The iterative method is illustrated in **Fig. 5a** and **Fig. 5b** and further illustrated in the next chapter where the procedure is executed on the N=10 model system. The variants of Fig. 5a and Fig. 5b are similar to a broad extent, therefore they are discussed in the following in common for a large part.
Initially an activation sequence is chosen 100, wherein a temporal sequence of cooling steps is chosen, according to step a). For this sequence of cooling steps, the temperatures $T_n$ for each bulk ring are determined experimentally as a function of time t 200 here, wherein here the temperature profiles $\underline{T}(t)$ are experimentally measured as a function of time t. Then, still in the first loop (iteration a=0), initial test conditions are set 300. This includes determining the temperature profiles $\underline{T}(k)$ after each cooling step of the sequence (with sequence index k) from the measurement (note that alternatively, the full information $\underline{T}(t)$ can be used); this also belongs to step b). Further, an initial test charger current pattern $\underline{c}^{test}(k)$ is defined arbitrarily. Note that alternatively, a full information on the charger current $I^{test}{}_{ch}(t)$ can be used. Determining $\underline{c}^{test}$ is also part of step c). Then follows the determination of the persistent currents $\underline{i}^{test}(k)$ in the bulk rings after each cooling step 400; note that in general the full information $\underline{i}^{test}(t)$ can be calculated for this purpose. This is also part of step c).
In the variant of Fig. 5a, then based on the results of step 400 the response matrix $\mathbf{M}$ and its inverse $\mathbf{Z}$ are determined 500, what is still part of step c). Based on $\mathbf{Z}$, a (new) charger current step pattern $\underline{c}$ is calculated 600, according to step d). Then it is checked whether the iteration result is good enough 700; note that after the first iteration (a=0), generally always a further iteration follows. For this purpose, in the variant of Fig. 5a, it is checked whether the obtained "target" current step pattern $\underline{c}$ of the current iteration deviates more than a threshold value from the one obtained with the previous iteration (this is also referred to with variant $\alpha$). If the deviation is more that the threshold value, the iteration result is not good enough, and another iteration is done; else the method may proceed to step 800. If another iteration is to be done, the charger current step pattern $\underline{c}$ of the current iteration acts as test charger current step pattern $\underline{c}^{test}$ in the next iteration, which it starts at step 400.

Once the result of the current iteration is good enough, see step 800, the charger current step pattern $\underline{c}$ resulting from step 600 of the final iteration can be used for the actual field cooling, which is in Fig. 5a a preparatory step which will be followed by a main field cooling step.

In the variant of Fig. 5b, after step 400, it is directly determined whether the result of the current iteration is good enough 701; note however that after the first iteration (a=0), generally always a further iteration follows. For determining whether the result of the current iteration is good enough, a test target persistent current pattern $\underline{i}^{test,target}$ is calculated, which can be taken from i(k), also noted as $\underline{i}^{test}(k)$, with k=N (Note that this corresponds to calculating $\underline{i}^{test,target}$ based on $\underline{i}^{test,target}=\mathbf{M}*\underline{c}^{test}$ of the current iteration). In a first sub-variant, also referred to as variant β, if $\underline{i}^{test,target}$ from the current iteration (a) deviates from $\underline{i}^{test,target}$ of the previous iteration (a-1) by more than a threshold value, then the result of the current iteration is considered not good enough, and another iteration should be done with steps 501, 601, else the method may proceed with step 801. In a second sub-variant, also referred to as variant γ, if $\underline{i}^{test,target}$ from the current iteration deviates from $\underline{i}^{target}$ by more than a threshold value, another iteration is done with steps 501, 601, else the method may proceed with step 801.

In step 501, which may be considered as part of step c), $\mathbf{M}$ and $\mathbf{Z}$ of the current iteration are determined based on the results of step 400, and in step 601, which corresponds to step d), a (new) charger current step pattern $\underline{c}$ of the current iteration is calculated, which will be used as test charger current step pattern $\underline{c}^{test}$ of the next iteration starting at step 400.

Once the result of the current iteration is good enough, see step 801, last calculated charger current step pattern $\underline{c}$ can be used for the actual field cooling, which is in Fig. 5b a preparatory step which will be followed by a main field cooling step. Note that in the variant of Fig. 5b, the last calculated charger current step pattern originates from step 601 of the previous iteration, and not of the final iteration (which does not have step 601 in the variant shown).

## 3. Application of a simple example with nested stacks (N=10).

### 3.1. Hardware setup and thermal model

In this paragraph an example of an easy-to-manufacture thermal control system for a double stack of bulk rings is given, and it is shown how the inventive method can be used to trap an arbitrary pattern of preparatory correction currents in the double stack using simple thermal controls and charger ramps.

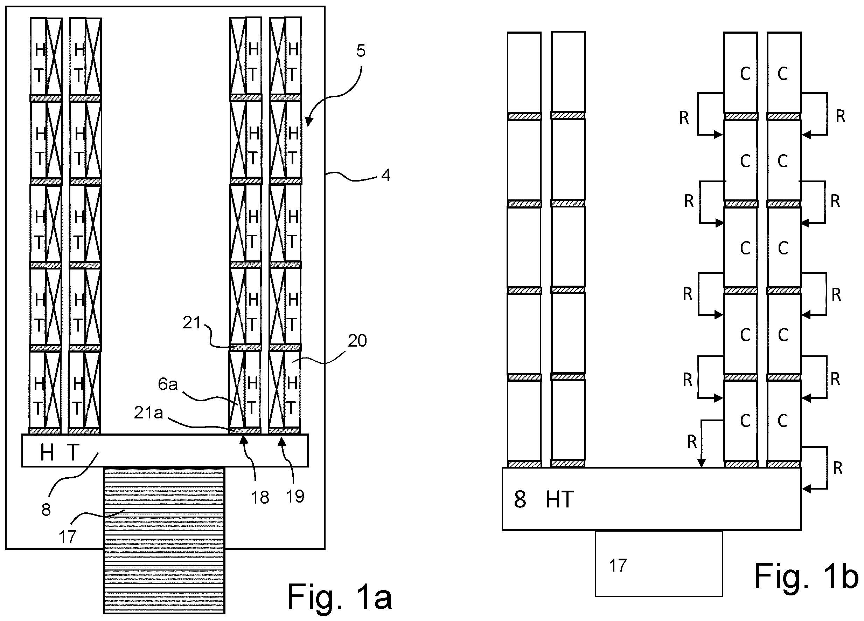

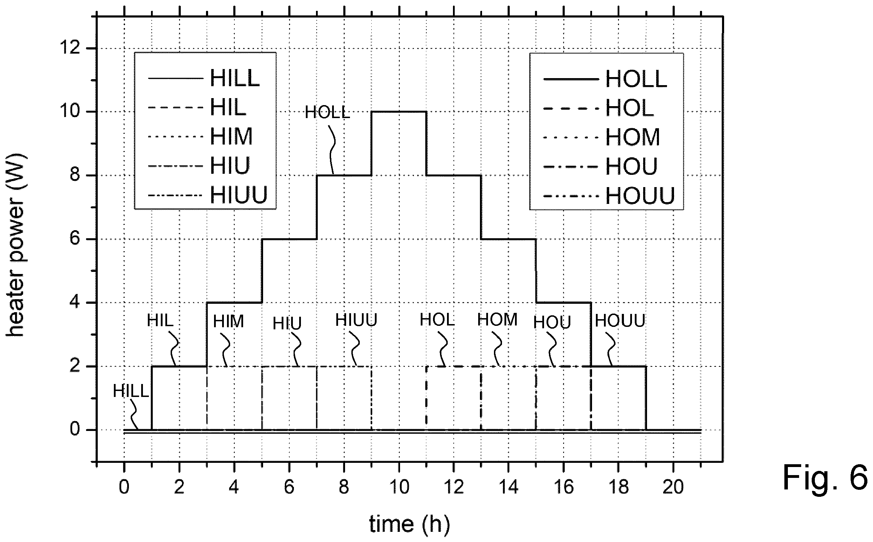

Again, a superconductor bulk magnet 5 with a (N=10) double stack of five bulk rings each is used as depicted in **Fig. 1a**. The radial inner stack 18 and the radial outer stack 19 each comprise five superconductor bulk sub-magnets, also called bulk rings (only one is indicated with reference sign 6a in Fig. 6a, for simplicity), which are axially arranged in sequence in a cryostat 4, with a lower end of the stacks 18, 19 thermally coupled to a common cooling stage 8 cooled by a cryocooler 17 (such as a pulse tube cooler).

Every bulk ring 6a is surrounded by a metal ring (or corset ring) 20 that serves both as a mechanical corset to handle hoop stress from the conductor, and as thermalization anchor for the superconductor. On each metal ring 20 there is a temperature adjustment unit HT with a heater (also called heater element) and a thermometer (also called temperature sensor), and between every corseted ring (i.e. the entirety of bulk ring 6a and metal ring 20) and its axial neighbors there is an intermediate thermal impedance 21 like e.g. a 2mm-thick G10-plate; analogously there is a first thermal impedance 21a between the lowermost corseted ring 6a, 20 and the cooling stage (also called thermal base) 8. The two rings 6a, 20 are separated by a vacuum gap which may be filled with a low thermal-conductivity spacer for mechanical support (not shown in detail).

The thermal base 8 is coupled directly to a heat sink equipped with a thermal control. In this example a cryocooler 17 with finite cooling capacity curve T(dQ/dt) is used, and the base temperature can be controlled using a simple heater/thermometer combination, i.e. another thermal adjustment unit HT, as long as the cooler 17 has enough cooling power to achieve the required temperature T at a given heat load dQ/dt. Note that in it is also possible to control the cooling power of the cryocooler 17 directly in order to control the temperature of the cooling stage 8, although this is, in general, relatively slow. Another possible embodiment can include an external cooler (not shown here, but described in post-published European patent application 20 174 683.1 incorporated by reference).

This system can be modelled thermally as a alternating sequence of impedances R (e.g. G10 plates, shown as hatched area fields in the spaces between the bulk rings) and lumped isothermal heat capacity nodes C (the corsetted bulk rings) with heat sources on every node (the heaters) and a temperature-controllable thermal sink below (the cooling base 8 / common cooling stage), compare **Fig. 1b**.

Applying a steady heating pattern to these heaters leads to a steady temperature pattern after some relaxation with time constant of order $\tau = RC$, where R is the thermal impedance given by the G10 plates, and C is the heat capacity of the corsetted bulk ring. This is in close analogy to an electrical R-C-cicuit, with R being the resistance in ohms, and C the capacitance in Farad.

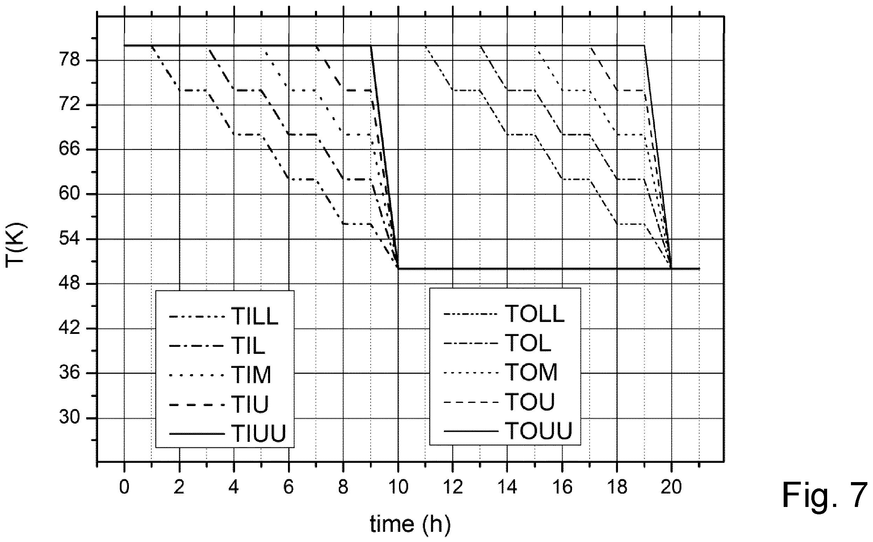

**Fig. 6** illustrates the heating pattern of the respective heaters (H, first letter) at the various bulk rings (of inner stack I and outer stack O as second letter, at axial positions from lowermost LL to uppermost UU, see before or Fig. 8), with heating power in W as a function of time (t) in hours h. **Fig. 7** illustrates the resulting temperature profiles at the temperature sensors (T, first letter) and the varous bulk rings, with temperatures in K and time (t) in hours.

Estimation of the time constant: The thermal impedance of a G10-plate of the depicted dimensions at 50-80 Kelvin is of the order of 3 K/W. This can be seen in the graphs of Fig. 6 and Fig. 7 from the equilibrium values (e.g. between t=2h and t=3h) wherein 2 W heating is needed for a 6 K gradient across the G10 plate between ILL and IL.

The heat capacity of a corsetted ring of the depicted dimension in that temperature range is of the order of 300-500 J/K (lower values at lower temperatures), and so we find a relaxation time constant of around 900-1500 sec, or 15-25 min. For the sake of simplicity, it is assumed here that the bulk rings are thermalized within one hour, and the relaxation is depicted as a linear trip from one temperature to the next. This is of course somewhat simplified, but the details of the thermal trip have no effect on the outcome of the simulation as long as the system is sufficiently relaxed thermally when the charger current is swept. This can safely be assumed to be the case here.

Applying the heating pattern of Fig. 6 (HILL: heater on inner lower lowest bulk etc) leads to the temperature profile $\underline{T}(t)$ of Fig. 7. Note that the base (common cooling stage) temperature is controlled so as to be identical to the depicted TILL (inner lowermost bulk ring).

The applied activation sequence (see also Fig. 8) is: ILL, IL, IM, IU, IUU, OLL, OL, OM, OU, OUU. Bulk rings are assumed to be

> Inactive: T$\geq$ 80 K, and
> Activated: T$\leq$ 74 K.

This activation pattern for the twin-stack bulk ring system is valid as

- The bulk rings are activated in an effective sequence (lower to upper, inner to outer) and
- The temperature of every single bulk ring only goes down after activation.

3.2. Executing the flow chart

*Iteration a=0*

**Fig. 8** illustrates once again the activation sequence. The starting temperature is 80 Kelvin, the starting field/charger current is 6 Tesla/120 A. The initial charger current step sequence is chosen here arbitrarily as a uniform -50 mA per step for the test charger current $I^{test}_{ch}$; note that in the definition of a charger current step pattern $\underline{c}$ or $\underline{c}^{test}$, or its respective current step increments $c_k$ or $c^{test}_k$, used here, there is included a factor of (-1) as compared to the actual current change, such that a current step that positively charges a bulk ring has a positive current step increment value. Further note that the initial charger current step pattern is assumed for the calculation of the response of the superconductor bulk magnet, and therefore is of "test" type:

$$\underline{c}^{test\,0} = \left(\begin{array}{cccccccccc} 50 & 50 & 50 & 50 & 50 & 50 & 50 & 50 & 50 & 50 \end{array}\right) mA$$

Iteration index a=0 indicates that we are in the initial loop.

This leads to simulated trapped persistent currents $\underline{i}(t)$ in the bulk sub-magnets as a function of time as shown in **Fig. 3**. Fig. 3 illustrates both the (test) charger current $I_{ch}^{test}$ (upper part/right hand ordinate) and the accumulated persistent currents i in the bulk rings (lower part/left ordinate) as a function of time t. Note that Fig. 3 belongs to the first iteration with iteration index a=0, with the first iteration comprising method steps a), b), c) and d).

The trapped current values for all bulk rings at t = 1.5 / 3.5 / ...21.5 h are identified and then are evaluated into response matrix $\mathbf{M}^0$, and the inverse $\mathbf{Z}^0$ is calculated, with the result shown in **Fig. 4**. Note here that the entries $M_{k,n}$ of a response matrix $\mathbf{M}$ are calculated via $M_{k,n}=cp_{k,n}/c^{test}_k$, i.e. via the change $cp_{k,n}$ of persistent current in bulk sub-magnet n after the kth charging step of increment $c^{test}_k$.

Note that the matrix $\mathbf{M}^0$ is dimensionless (amps trapped in bulk rings per amps charger ramp), and so is $\mathbf{Z}^0$. $\mathbf{M}^0$ naturally has large values for the elements, as a small ramp in charger current induces comparatively large changes in trapped currents (the charger has thousands of turns). In turn, the elements of the inverse $\mathbf{Z}^0$ are small.

The target trapped currents, i.e. target persistent current pattern $\underline{i}^{target}$, have been chosen here to be the first ten multiples of 50 A (for sake of intuitive and easily readable current charts):

$$\underline{i}_{target} = \begin{pmatrix} 500 & 450 & 400 & 350 & 300 & 250 & 200 & 150 & 100 & 50 \end{pmatrix} A$$

Using the equation $\underline{c} = \mathbf{Z} * \underline{i}^{target}$, the "first-order" charger current steps (charger current step pattern c resulting from the first calculation loop with index a=0) result in:

$$\underline{c}^0 = \begin{pmatrix} -59.45 & 73.09 & 95.35 & 121.17 & 82.88 & -9.62 & 41.35 & 43.79 & 41.98 & 29.11 \end{pmatrix} mA$$

This charger current step pattern $\underline{c}^0$ is used as the test current step pattern $\underline{c}^{test\ 1}$ in the next iteration with iteration index a=1, i.e. $\underline{c}^0 = \underline{c}^{test\ 1}$.

*Iteration a=1*

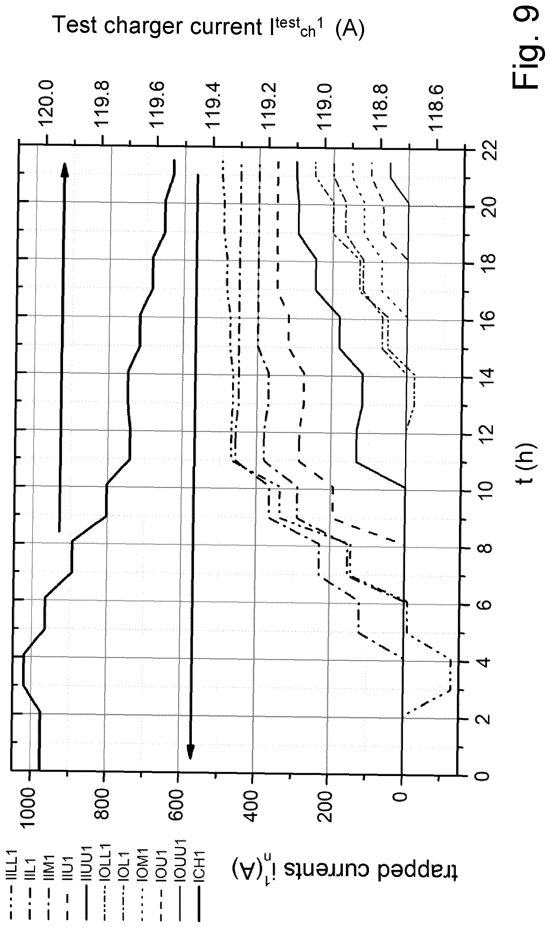

Applying this next test charger current step pattern $\underline{c}^{test\ 1}$ (compare $I^{test}_{ch}{}^1(t)$ on right ordinate) to the forward numerical model yields the persistent currents $i_n{}^1$ (t) (compare left ordinate) as shown in **Fig. 9**. Note that iteration a=1 is an intermediate iteration including steps c) and d).

Looking at the trapped currents at time t = 21.5 h, it is clear that the target currents are met rather nicely. Evaluating the chart at t = 21.5 h yields the following trapped currents $\underline{i}^{test,target\ 1}$:

$$\underline{i}^{test,target\ 1} = \begin{pmatrix} 500.321 & 448.830 & 399.595 & 349.694 & 300.245 & 250.674 & 200.279 & 150.225 & 100.113 & 50.044 \end{pmatrix} A$$

which is quite close to our target current pattern $\underline{i}^{target}$ (see above).

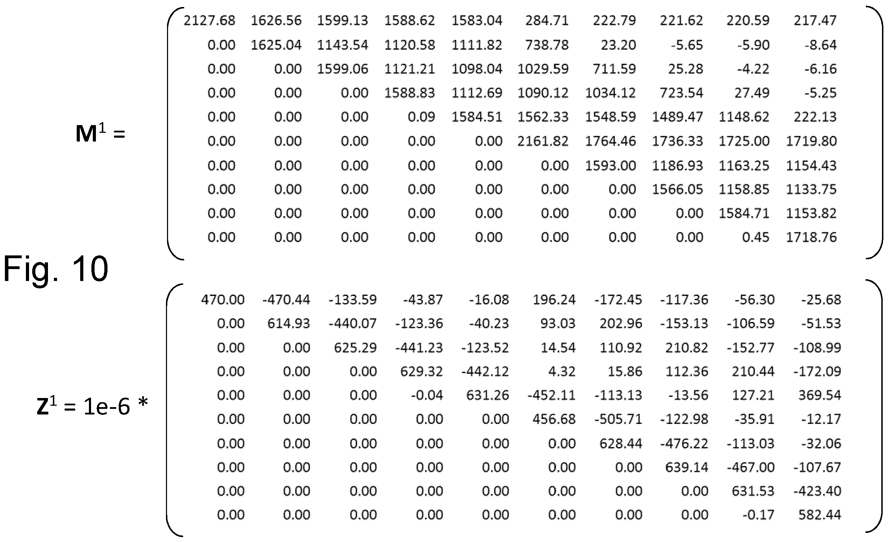

Evaluation of the current values for all bulk rings at t= 1.5/ 3.5/ ...21.5 h and renormalization to charger current step deltas leads to the first-order response matrix $\mathbf{M}^1$ and its inverse $\mathbf{Z}^1$, illustrated in **Fig. 10.**

Again, we calculate the charger current steps $\underline{c}^1$ resulting from this iteration a=1, which will be the test charger current pattern $\underline{c}^{test\ 2}$ for the next iteration a=2, according to $\underline{c}^1 = \underline{c}^{test\ 2} = \mathbf{Z}^1 * \underline{i}^{target}$ resulting in

$$\underline{c}^{test\ 2} = \begin{pmatrix} -60.27 & 73.53 & 95.43 & 121.42 & 83.03 & -9.75 & 41.29 & 43.70 & 41.93 & 29.08 \end{pmatrix} mA$$

*interation a=2*

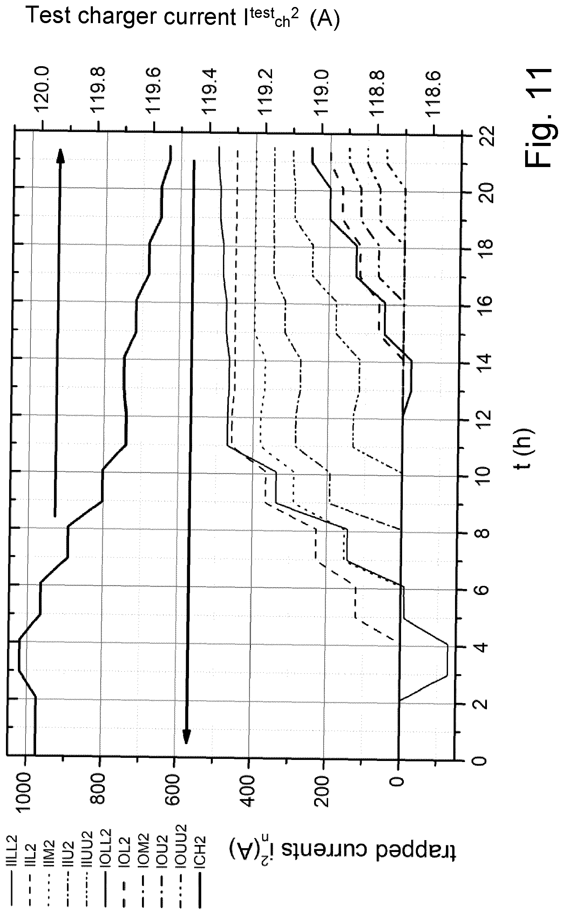

Applying this test charger current step pattern $\underline{c}^{test\ 2}$ (compare $I^{test}_{ch}{}^2(t)$ on right ordinate) to the forward numerical model yields the persistent currents $i_n{}^2$ (t) (compare left ordinate) as shown in **Fig. 11**.

Evaluating the chart of Fig. 11 at t = 21.5 h yields the following trapped currents:

$$\underline{i}^{test,target\ 2} = \begin{pmatrix} 500.007 & 449.992 & 400.001 & 349.999 & 300.000 & 249.998 & 200.002 & 150.001 & 100.000 & 50.000 \end{pmatrix} A$$

Remembering that

$$\underline{i}_{target} = \begin{pmatrix} 500 & 450 & 400 & 350 & 300 & 250 & 200 & 150 & 100 & 50 \end{pmatrix} A$$

here. By comparison to the defined target current values $\underline{i}^{target}$, we find the match to be sufficiently close to end the iterative process at this point in accordance to the criterion (which we may set as low as 2ppm for the deviation between $i^{test,target\ 2}$ and $i^{target}$ in this example) for the "good enough" criterion in Fig. 5b. The last calculated charger current step pattern $\underline{c}^1$ can be used for the actual preparatory field cooling step.

As a side remark, when stopping the iteration a=2 here, this final iteration includes only step c), and does without a step d) and without a calculation of $\underline{c}^2$, since $\underline{c}^1 = \underline{c}^{test\ 2}$ already led to a sufficient match of $i^{test,target\ 2}$ and $i^{target}$. However, if desired, a step d) can be included in the final iteration, calculating $\underline{c}^2 = \mathbf{Z}^2 * \underline{i}^{target}$ with $\mathbf{Z}^2 = inv(\mathbf{M}^2)$, and then $\underline{c}^2$ can be used for the actual preparatory field cooling step.

After only one initial simulation run (first iteration a=0) and two iterative simulation runs (intermediate iteration a=1 and final iteration a=2), the method is within about 2ppm of the target values and converges quickly. In this specific example, around one order of magnitude gain in accuracy per iteration cycle was observed.

So in summary, with respect to the advance calculation (simulation) of the inventive method, it can be seen that

- The method is general and quickly converging;
- The achievable numerical precision after 2-3 runs is orders of magnitude

smaller than the foresseable imperfections in experimental errors and material/production scatter.

## 4. Preparatory field cooling step and main field cooling step

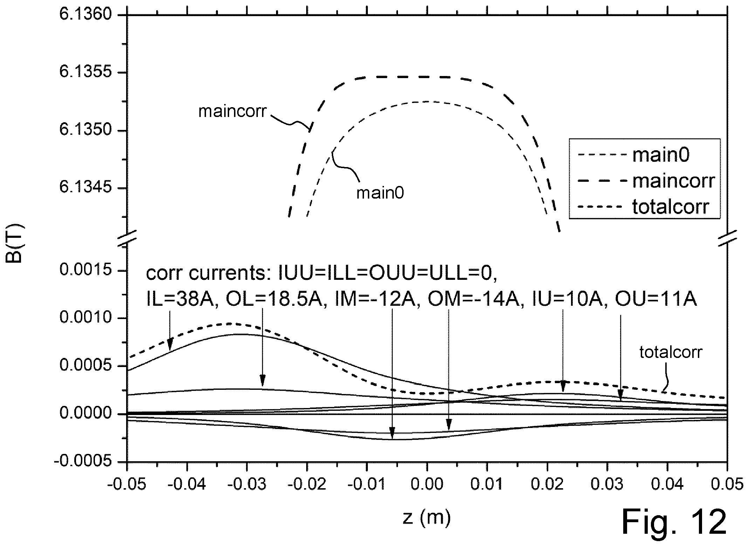

**Fig. 12** illustrates by way of example an application of the inventive method on homogenizing a magnetic field generated by a superconductor magnet system charged by field cooling. Fig. 12 illustrates on the ordinate a magnetic field B in Tesla, on the upper half of a superconductor bulk magnet in total and on the lower half for individual bulk sub-magnets or for a preparatory step, respectively, and on the abscissa the location on the z axis in meters, centered in the sample volume.

When directly charging the superconductor sub-magnet with the electrical charger magnet, in the example shown, the bulk sub-magnets are charged according to a main persistent current pattern $\underline{h}$ (not illustrated in detail), which results in a comparably inhomogeneous magnetic field main0 (see Fig. 12, upper half, thin dashed line). The inhomogeneities may result in particular from the geometry of the charger setup, a finite axial length of the superconductor bulk sub-magnet, and material imperfections in the superconductor material, such as pores.

The profile of the magnetic field main0 can be measured, e.g. with a Hall probe, and a set of correction currents for the available superconductor sub-magnets can be determined then. Note that depending on the type and degree of inhomogeneity, it may be enough to set correction currents only for a part of the available superconductor sub-magnets. The determined correction currents represent a target persistent current pattern $\underline{i}^{target}$ in the inventive method.

By means of the inventive method, then a charger current step pattern $\underline{c}$ can be calculated based on a chosen temporal sequence of cooling steps $cs_k$ and the desired (i.e. required for correction) target persistent current pattern $\underline{i}^{target}$.

Then, in a preparatory field cooling step, the target persistent current pattern of $\underline{i}^{target}$ is actually established at the bulk sub-magnets, by applying the chosen temporal sequence of cooling steps and the calculated charger current step pattern. In the example, $\underline{i}^{target}$ comprises zero currents for the sub-magnets IUU, ILL, OUU and ULL, whereas the sub-magnets IL, OL, IM, OM, IU and OU are assigned finite currents as noted in Fig. 12, lower part. These sub-magnets generate a contribution to the magnetic field each, see full lines in the lower part of Fig. 12, and together, they generate a contribution totalcorr, see dashed line in the lower part of Fig. 12.

After the preparatory field cooling step, the main field cooling step follows, in which the charger current is ramped down to zero with all sub-magnets below their $T_c$, and thus being charged according to the main persistent current pattern h. As a result, the contributions of totalcorr and main0 superimpose, resulting in a corrected magnetic field maincorr, as illustrated in Fig. 12, upper part, see bolt dashed line. As can be seen in Fig. 12 top part, the corrected magnetic field maincorr based on the sum current pattern $\underline{s}=\underline{h}+\underline{i}^{target}$ is much more homogenous than the field main0 based on the main persistent current pattern h alone. In the example, when assuming a sample volume from -0.01 m to +0.01 m, field main0 has a field variation of about 0.00025 T (at a field strength of about 6.135 T), corresponding to about 40 ppm, whereas field maincorr has a field variation of about 0.00005, corresponding to about 8 ppm.

## 5. Detailed description of a charger arrangement for the invention

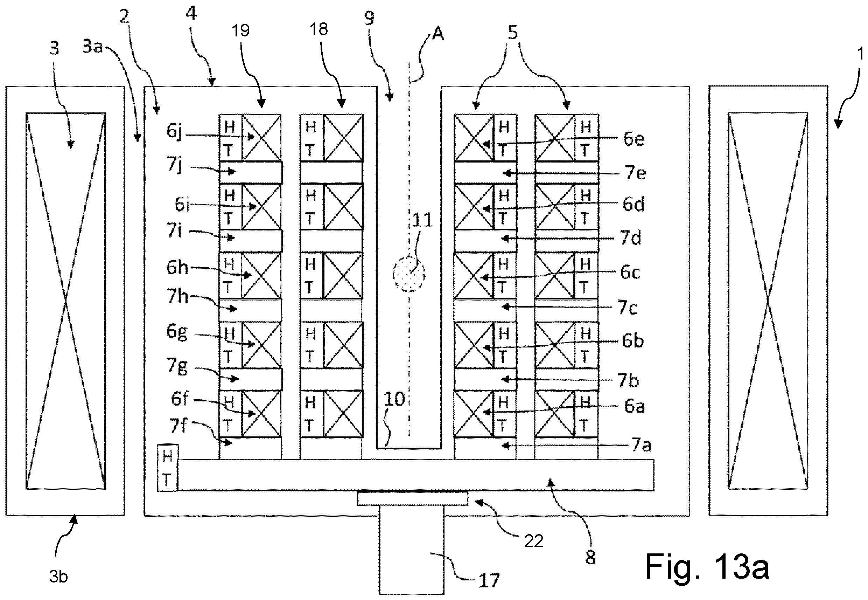

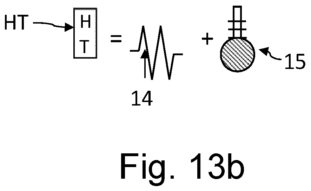

**Fig. 13a** illustrates by way of example a charging arrangement 1, comprising a superconductor bulk magnet system 2 (see also Figs. 1a, Fig. 1b, Fig. 2) arranged in an electrical charger magnet, 3, in particular for applying the inventive charging method described above, in a schematic cross-section along the z axis (compare axis A). **Fig. 13b** schematically illustrates the heaters and thermometers of the thermal adjustment units HT of Fig. 13b.

In the charger arrangement 1, the superconductor magnet system 2 comprises a superconductor bulk magnet 5 comprising a number of superconductor bulk sub-magnets 6a-6j and a cooling system 22. The bulk sub-magnets 6a-6j are of ring shape, arranged coaxially about axis A, which is along the z axis, and are made of a superconductor material, here a high temperature superconductor material. This axis A is coaxial with an axis of a room temperature bore 10 of a cryostat 4 housing the superconductor bulk magnet 5, and coaxial with a magnetic axis of the electrical charger magnet 3. The electrical charger magnet 3a has a charger bore 3a, in which the superconductor bulk magnet 5 is arranged. In the example shown, the electrical charger magnet 3 is also of superconductor type and arranged within a charger cryostat 3b.

In the room temperature bore 10 of the cryostat 4, there is located the sample volume 11, which can be used e.g. for NMR measurements once the superconductor bulk magnet 5 is charged. The sample volume 11 lies within the superconductor bore 9 of the superconductor bulk magnet 5.

In the illustrated example, the superconductor bulk magnet 5 comprises a radially inner stack 18 and a radially outer stack 19 of bulk sub-magnets 6a-6j, with each stack 18, 19 comprising five sub-magnets 6a-6e, 6f-6j stacked along the axis A. Between a common cooling stage 8 and a respective first bulk sub-magnet 6a, 6f, and also between each pair of axially neighboring sub-magnets 6a-6j in a stack 18, 19, there is arranged an intermediate body 7a-7j. These intermediate bodies are also called thermal impedances, which couple the bulk sub-magnets 6a-6e, 6f-6j in linear sequence. The thermal impedances 7a, 7f between the common cooling stage 8 and the first bulk sub-magnets 6a, 6f in the sequence are called first thermal impedances, and the others are called intermediate thermal impedances 7b-7e, 7g-7j. The thermal impedances 7a-7j are non-adjustable. Note that apart from the linear sequence of thermal impedances 7a-7j and bulk sub-magnets 6a-6j, there is no (solid state type) thermal coupling of the bulk sub-magnets 6a-6j to the common cooling stage 8.

The cooling system 22 comprises the common cooling stage 8, a cryocooler 17 coupled to the common cooling stage 8, as well as thermal adjustment units HT for the cooling stage 8 and each sub-magnet 6a-6j. A respective thermal adjustment unit comprises a heater (heater element) 14, here of electrical heater element type, and a thermometer (thermal sensor) 15. The heater 14 and the thermometer 15 of each bulk sub-magnet is arranged in a corseting metal ring attached to each bulk sub-magnet in the embodiment shown.

By means of the common cooling stage 8 and the heaters 14, starting from a warm state (above the critical temperature $T_c$) of all bulk sub-magnets, it is possible to sequentially cool down the bulk sub-magnets 6a-6e, 6f-6j in each stack 18, 19, starting at the first (end side) bulk sub-magnet 6a, 6f closest to the cooling stage, and stepwise cooling down the respective next (axially further up) bulk sub-magnet.

In general, first the inner stack 18 is sequentially cooled down completely, and then the outer stack 19 is sequentially cooled down completely (see e.g. Figs. 6 and 7 for a typical cooling procedure). Within the example of Fig. 6, which will be discussed here with reference to Fig. 13a and 13b, for cooling the inner stack 18, the temperature at the common cooling stage 8 is stepwise lowered, and a local blocking heating power is moved axially upward on the inner stack 18 ring by ring from bulk ring 6b to bulk ring 6e. At the same time, at the outer stack 19, the blocking heating power at the lowermost bulk ring 6f is stepwise increased, in order to keep first bulk ring 6f warm, and thus the whole stack 19. After having cooled the inner stack 18 completely, the radially outer stack 19 is cooled down. For this purpose, the temperature of the cooling stage 8 remains fixed now, and the heating power at the lowermost bulk ring 6f is stepwise reduced, what initially cools down the lowermost bulk ring 6f, and then allows cooling of further bulk rings 6g-6j of the stack 19. For the latter purpose, a blocking heating power is moved axially upward on the outer stack 19 ring by ring from bulk ring 6b to 6j. Finally, the heating power at all bulk rings 6a-6j has been lowered to zero, and the bulk sub-magnets 6a-6j are all cold (below their critical temperature $T_c$).

As far as the charging procedure is concerned, initially the charger magnet 3 is charged (i.e. the charger current $I_{ch}$ is moved up) with the superconductor bulk sub-magnets 6a-6j all warm (above $T_c$). Then in a preparatory field cooling procedure (step), the bulk sub-magnets 6a-6j are charged stepwise, with in each step one further bulk sub-magnet being lowered below $T_c$ as described above, and a little change of the charger current $I_{ch}$ taking place (compare charger current step pattern c). Once all desired sub-magnets 6a-6j have been charged a little according to a (preparatory) target persistent current pattern, then a main field cooling procedure (step) follows, wherein with all bulk sub-magnets below $T_c$, the charger magnet is discharged, i.e. the charger current $I_{ch}$ is completely ramped down again. With the target persistent current pattern $\underline{i}^{target}$ chosen properly, very high homogeneity of the magnetic field in the sample volume 11 can be achieved, even without shim coils inside the superconductor bore 9.

In summary, the invention relates to a method for charging a superconductor magnet system (2) comprising N superconductor bulk sub-magnets (6a-6j), wherein the N superconductor bulk sub-magnets (6a-6j) are charged by a field cooling process, wherein at least temporarily the temperatures $\underline{T}=(T_n: n=1...N)$ of the N superconductor bulk sub-magnets (6a-6j) are chosen different from each other, with n: superconductor bulk sub-magnet index,

is characterized in that $N \geq 4$,
that in an advance calculation, the following steps are applied:

a) a temporal sequence of cooling steps $cs_k$ is chosen, in each of which one more superconductor bulk sub-magnet (6a-6j) is cooled below its critical temperature $T_c$, with k: sequence index, with k=1...N;
b) for each state $st_k$ of the superconductor bulk magnet (5) obtained after a respective cooling step $cs_k$, a distribution of temperatures $\underline{T}(k)$ of the superconductor bulk sub-magnets (6a-6j) is determined, with $\underline{T}(k)=(T_n(k): n=1...N)$,
c) for each state $st_k$ of the superconductor bulk magnet (5) obtained after a respective cooling step $cs_k$, a response of the superconductor bulk sub-magnets (6a-6j) to a change of the charger current $I_{ch}$ is calculated,
d) a charger current step pattern $\underline{c}=(c_k: k=1...N)$ is calculated, with current step increment $c_k:=[I_{ch}$(after current step in state $st_k$) - $I_{ch}$(before current step in state $st_k$)]*(-1), such that a target persistent current pattern

$\underline{i}^{target}=(i_n^{target}: n=1...N)$ in the superconductor bulk sub-magnets (6a-6j) would result, based on the responses calculated in step c),
and that the superconductor magnet system (2) is subjected to the field cooling process, applying the temporal sequence of cooling steps $cs_k$ the charger current step pattern c. Thus setting a desired target persistent current pattern can be accomplished easily, in particular for a larger number of bulk sub-magnets.

List of reference signs:

| | |
|---|---|
| 1 | charging arrangement |
| 2 | superconductor magnet system |
| 3 | electric charger magnet |
| 3a | charger bore |
| 3b | charger cryostat |
| 4 | cryostat (superconductor magnet system) |
| 5 | superconductor bulk magnet |
| 6a | lowermost inner bulk sub-magnet / first bulk sub-magnet |
| 6b | lower inner bulk sub-magnet |
| 6c | mid inner bulk sub-magnet |
| 6d | upper inner bulk sub-magnet |
| 6e | uppermost inner bulk sub-magnet |
| 6f | lowermost outer bulk sub-magnet / first bulk sub-magnet |
| 6g | lower outer bulk sub-magnet |
| 6h | mid outer bulk sub-magnet |
| 6i | upper outer bulk sub-magnet |
| 6j | uppermost outer bulk sub-magnet |
| 7a, 7f | intermediate bodies / first thermal impedances |
| 7b-7e, 7g-7j | intermediate bodies / intermediate thermal impedances |
| 8 | thermal base / common cooling stage |
| 9 | superconductor bore |
| 10 | room temperature bore |
| 11 | sample volume |
| 12 | sheet |
| 14 | heater element |
| 15 | temperature sensor |
| 17 | cryocooler |
| 18 | (radially inner) stack |
| 19 | (radially outer) stack |
| 20 | metal ring |
| 21 | intermediate thermal impedance |
| 21a | first thermal impedance |
| 22 | cryogenic cooling system |
| A | central axis |
| C | (thermal) capacity |
| HT | temperature adjustment unit, comprising heater / heating element ("H") and thermometer / thermal sensor ("T") |
| R | (thermal) resistance |

List of variables and parameters

| | |
|---|---|
| $T_c$ | : critical temperature of the bulk superconductor |
| $j_c(B, T)$ | : critical current density at field B and temperature T |
| N | : number of superconductor bulk sub-magnets ("bulk rings") |
| n | : superconductor bulk sub-magnet index, n= 1...N |
| k | : sequence index, k = 1... N |
| t | : time |
| d | : node index (first model) |

(continued)

| | |
|---|---|
| D | : Number of nodes (first model) |
| a | : iteration index |
| $cs_k$ | : k-th cooling step of the superconductor bulk magnet, k=1...N |
| $st_k$ | : k-th state of the superconductor bulk after cooling step $cs_k$ |
| $c_k$ | : k-th (charger) current step increment, k=1...N |
| $\underline{c} := (c_k: k=1...N)$ | : (charger) current step pattern |
| $c^{test}_k$ | : k-th test (charger) current step increment, k=1...N |
| $\underline{c}^{test} = (c^{test}_k: k=1...N)$ | : test (charger) current step pattern |
| $I_{ch}$ | : charger current |
| $I^{test}_{ch}$ | : test charger current |
| $i^{test}_n$ | : persistent current through n-th bulk ring (noted typically as a function of time t or of sequence index k, after the charger current step in state $st_k$, and sometimes simply noted $i_n$) |
| $\underline{i}^{test} := (i^{test}_n: n=1...N)$ | : test persistent current vector (noted typically as a function of time t or of sequence index k, after the charger current step in state $st_k$, and sometimes simply noted $\underline{i}$) |
| $\underline{i}^{test,target} := (i_n^{test,target}: n=1...N)$ | : test target persistent current pattern, resulting from response with $\underline{c}^{test}$, typically calculated with $\underline{i}^{test,target}=\mathbf{M}*\underline{c}^{test}$ or determined as $\underline{i}^{test,target} =\underline{i}^{test}(N)$; |
| $\underline{i}^{target} := (i_n^{target}: n=1...N)$ | : target persistent current pattern |
| $cp_{k,n}$ | : change in persistent current in n-th bulk in state $st_k$; k, n = 1...N |
| $T_n$ | : temperature of n-th bulk |
| $\underline{T} := (T_n: n=1...N)$ | : temperature distribution of the superconductor bulk sub-magnets |
| $M_{k,m} := cp_{k,m}/ c^{test}_k$ | : response to test pattern, normalized to test current step increment |
| $\mathbf{M} := (M_{k,n}: k, n=1...N)$ | : response matrix |
| $\mathbf{Z} := inv(\mathbf{M})$ | : inverse of the response matrix |
| $\underline{h} := (h_n: n=1...N)$ | : ("virgin") main persistent current pattern, i.e. $\underline{c}=0$ |
| $\underline{s} := \underline{i}^{target}+\underline{h}$ | : (corrected) sum current pattern |

In general, an underlining indicates a vector, and a bold print indicates a matrix.

List of references

1) Post-published European patent application 20 174 683.1;
2) US 7 859 374 B2 (corresponding to JP 5 143006 B2);
3) Internet page referring to "LTspice", https://www.analog.com/en/design-center/design-tools-and-calculators/lt-spice-simulator.htmlas of March 29, 2021;
4) WO 2016/161336 A1;
5) EP 3 657 193 B1
6) US 8,948,829 B2
7) US 2019/0178961 A1

**Claims**

1. Method for charging a superconductor magnet system (2),

with the superconductor magnet system (2) comprising

- a superconductor bulk magnet (5), with the superconductor bulk magnet (5) comprising N superconductor bulk sub-magnets (6a-6j), with N≥4,
- and a cooling system (22) for the N superconductor bulk sub-magnets (6a-6j),

wherein the superconductor bulk magnet (5) is arranged in a charger bore (3a) of an electrical charger magnet (3),

wherein the N superconductor bulk sub-magnets (6a-6j) are charged by a field cooling process, such that a target persistent current pattern $\underline{i}^{target}=(i_n^{target}: n=1...N)$ in the superconductor bulk sub-magnets (6a-6j) is achieved, wherein an electric current $I_{ch}$ in the electrical charger magnet (3) is changed, with n: superconductor bulk sub-magnet index,

**characterized in**

**that** the cooling system (22) is adapted to individually set temperatures $T_n$ of the N superconductor bulk sub-magnets (6a-6j),

**that** during the field cooling process, at least temporarily the temperatures $\underline{T}=(T_n: n=1...N)$ of the N superconductor bulk sub-magnets (6a-6j) are chosen different from each other,

**that** in an advance calculation, the following steps are applied:

a) a temporal sequence of cooling steps $cs_k$ is chosen, wherein starting from a state of the superconductor bulk magnet (5) with all its superconductor bulk sub-magnets (6a-6j) above their critical temperature $T_c$, in each cooling step $cs_k$ of the temporal sequence, one more superconductor bulk sub-magnet (6a-6j) is cooled below its critical temperature $T_c$, with k: sequence index, with k=1...N;

b) for each state $st_k$ of the superconductor bulk magnet (5) obtained after a respective cooling step $cs_k$, a distribution of temperatures $T(k)$ of the superconductor bulk sub-magnets (6a-6j) is determined, with $\underline{T}(k)=(T_n(k): n=1...N)$,

c) for each state $st_k$ of the superconductor bulk magnet (5) obtained after a respective cooling step $cs_k$, a response of the superconductor bulk sub-magnets (6a-6j) to a change of the charger current $I_{ch}$ is calculated, taking into account at least a geometry of the charger magnet (3), a geometry of the superconductor bulk magnet (5), a background magnetic flux density B generated by the electrical charger magnet (3), and a critical current density $j_c(B, T_n(k))$ of the superconductor bulk sub-magnets (6a-6j) at their applicable temperature $T_n(k)$ determined in step b) for the respective state $st_k$,

d) a charger current step pattern $\underline{c}=(c_k: k=1...N)$ is calculated, with current step increment $c_k: =[I_{ch}($after current step in state $st_k) - I_{ch}($before current step in state $st_k)]*(-1)$, with the current step increment $c_k$ of the charger current step pattern c to be applied in respective state $st_k$ of the superconductor bulk magnet (5) such that the target persistent current pattern $\underline{i}^{target}=(i_n^{target}: n=1...N)$ in the superconductor bulk sub-magnets (6a-6j) would result, based on the responses calculated in step c),

and **that** the superconductor magnet system (2) is subjected to the field cooling process, applying the temporal sequence of cooling steps $cs_k$ chosen in step a) and applying the charger current step pattern c calculated in step d), thus establishing the target persistent current pattern $\underline{i}^{target}=(i_n^{target}: n=1...N)$ in the superconductor bulk magnet.

2. Method according to claim 1, **characterized in**

   **that** in step c), for calculating the responses, a test charger current step pattern $\underline{c}^{test}=(c^{test}_k: k=1...N)$ of test current step increments $c^{test}_k$ of a test charger current $I^{test}_{ch}$ is chosen, with $c^{test}_k: =[I^{test}_{ch}($after current step in state $st_k) - I^{test}_{ch}($before current step in state $st_k)]*(-1)$, wherein persistent currents accumulating in the superconductor bulk sub-magnets (6a-6j) as a result of the subsequent application of the test current step increments $c^{test}_k$ in the states $st_k$ are calculated,

   and **that** for each test current step increment $c^{test}_k$ a change $cp_{k,n}$ of persistent current in each superconductor bulk sub-magnet n=1...N (6a-6j) in state $st_k$ is calculated, and a response $M_{k,n}$ of superconductor bulk sub-magnet n (6a-6j) in state $st_k$ is determined with $M_{k,n}=cp_{k,n}/c^{test}_k$.

3. Method according to claim 2, **characterized in that** a response matrix M is calculated, with $\mathbf{M}=(M_{k,n}: k=1...N$ and $n=1...N)$,

   and **in that** in step d), for calculating the charger current step pattern c for the target persistent current pattern $\underline{i}^{target}$, the linear equation system $\underline{i}^{target} =\mathbf{M}*\underline{c}$ is solved for $\underline{c}$.

4. Method according to claim 3, **characterized in that** in step d), for calculating the charger current step pattern c for the target persistent current pattern $\underline{i}^{target}$, an inverse matrix $\mathbf{Z}:=inv(\mathbf{M})$ is calculated, and c is determined with $\underline{c}=\mathbf{Z}*\underline{i}^{target}$.

5. Method according to one of the claims 2 through 4, **characterized in that** in step c) a first model is applied which includes

- dividing each superconductor bulk sub-magnet (6a-6j) into a plurality of radially nested and axially stacked sheets (12), and
- calculating sheet persistent currents accumulating in the sheets (12) as a result of the subsequent application of the test current step increments $c^{test}_k$ of the test charger current step pattern $\underline{c}^{test}$,

and further that a second model is applied which includes

- for each superconductor bulk sub-magnet n (6a-6j) after application of each test current step increment $c^{test}_k$, summing the sheet persistent currents of all sheets (12) belonging to the respective superconductor bulk sub-magnet n (6a-6j) into a summed persistent current, and determining the changes of persistent current $cp_{k,n}$ from the summed persistent currents.

6. Method according to one of the claims 2 through 5, **characterized in that** the method comprises a plurality of iterations, comprising

- a first iteration including step a), step b), step c) and step d),
- optionally one or more intermediate iterations including step c) and step d), and
- a final iteration including step c) and optionally step d),
that in the first iteration, in step c), the test charger current step pattern $\underline{c}^{test}$ is chosen arbitrarily, in particular with equal test current step increments $c^{test}_k$,
that in one or more subsequent iterations, the charger current step pattern c resulting from step d) of the previous iteration is used as test charger current step pattern $\underline{c}^{test}$ in step c) of the current iteration,
and that when the superconductor magnet system (2) is subjected to the field cooling process, the charger current step pattern $\underline{c}$ calculated in step d) of a last iteration that included step d) is applied.

7. Method according to claim 6, **characterized in that**

$\alpha$) the final iteration includes a step d), and if a difference between a charger current step pattern $\underline{c}$ of the current iteration and a charger current step pattern $\underline{c}$ of the previous iteration is more than a threshold value, then another iteration is performed, else the current iteration is the final iteration and no more iteration is performed, or
$\beta$) for each iteration, in step c) a test target persistent current pattern $\underline{i}^{test,target}=(i_n^{test,target}: n = 1... N)$ in the superconductor bulk sub-magnets (6a-6j) is calculated based on the test charger current step pattern $\underline{c}^{test}$ of the current iteration, and if a difference between the test target persistent current pattern $\underline{i}^{test,target}$ of the current iteration and the test target persistent current pattern $\underline{i}^{test,target}$ of the previous iteration is more than a threshold value, then another iteration is performed, else the current iteration is the last iteration and no more iteration is performed, in particular wherein the final iteration does not include a step d), or
$\gamma$) for each iteration, in step c) a test target persistent current pattern $\underline{i}^{test,target}=(i_n^{test,target}: n=1...N)$ in the superconductor bulk sub-magnets (5) is calculated based on the test charger current step pattern $\underline{c}^{test}$ of the current iteration, and if a difference between the test target persistent current pattern $\underline{i}^{test,target}$ of the current iteration and the target persistent current pattern $\underline{i}^{target}$ is more than a threshold value, then another iteration is performed, else the current iteration is the final iteration and no more iteration is performed, in particular wherein the final iteration does not include a step d).

8. Method according to one of the preceding claims, **characterized in**

**that** the superconductor bulk magnet (5) is chosen with at least one stack (18, 19) of axially stacked superconductor bulk sub-magnets (6a-6j), thermally linked in a linear sequence via thermal impedances (7a-7j), with an end side superconductor bulk sub-magnet (6a, 6f) of the stack (18, 19) thermally linked to a cooling stage (8), and **that** in step a) the temporal sequence of cooling steps $cs_k$ is chosen such that in a respective stack (18, 19), superconductor bulk sub-magnets (6a-6j) of the linear sequence closer to the cooling stage (8) are cooled below their critical temperature $T_c$ before superconductor bulk sub-magnets (6a-6j) of the linear sequence farther away from the cooling stage (8).

9. Method according to one of the preceding claims, **characterized in that** the superconductor bulk magnet (5) is chosen with at least two radially nested stacks (18, 19) of axially stacked superconductor bulk sub-magnets (6a-6j), and that in step a) the temporal sequence of cooling steps $cs_k$ is chosen such that superconductor bulk sub-magnets (6a-6e) of a stack (18) radially farther inside are cooled below their critical temperature $T_c$ before superconductor bulk sub-magnets (6f-6j) of a stack (19) radially farther outside.

10. Method according to one of the preceding claims, **characterized in that** in step b), the distributions $\underline{T}(k)$ of temperatures of the superconductor bulk sub-magnets (6a-6j) in the states $st_k$ are determined experimentally for the temporal sequence of cooling steps $cs_k$ chosen in step a), wherein thermal sensors (15) at the superconductor bulk sub-magnets (6a-6j) are read out, and wherein control parameters of the cooling system (22) applied for establishing the temporal sequence of cooling steps $cs_k$ are recorded,

and that when the superconductor magnet system (2) is subjected to the field cooling process, the temporal sequence of steps $cs_k$ of step a) is applied using the same control parameters of the cooling system (22).

11. Method according to one of the preceding claims, **characterized in that** after the target persistent current pattern $\underline{i}^{target}=(i_n{}^{target}: n=1...N)$ has been established in the superconductor bulk magnet (5) by the field cooling process, then a main field cooling process is performed,

that during the main field cooling process, all N superconductor bulk sub-magnets (6a-6j) are below their critical temperature $T_c$, and the charger current $I_{ch}$ is further varied, in particular reduced to zero, such that the main field cooling process adds a main persistent current pattern $\underline{h}=(h_n: n=1...N)$ to the target persistent current pattern $\underline{i}^{target}=(i_n: n=1...N)$ in the superconductor bulk sub-magnets (6a-6j),

and that the target persistent current pattern $\underline{i}^{target}=(i_n{}^{target}: n=1...N)$ has been chosen such that a magnetic field in a sample volume (11) of the superconductor bulk magnet (5) based on a sum current pattern $\underline{s}=\underline{i}^{target}+\underline{h}$ is more homogeneous than a magnetic field in the sample volume (11) of the superconductor bulk magnet (5) that would result based on the main persistent current pattern $\underline{h}$ alone.

12. A superconductor magnet system (2), comprising

- a superconductor bulk magnet (5), with the superconductor bulk magnet (5) comprising N superconductor bulk sub-magnets (6a-6j),
- and a cooling system (22) for the N superconductor bulk sub-magnets (6a-6j),

wherein the superconductor bulk magnet (5) comprises at least one stack (18, 19) of axially stacked superconductor bulk sub-magnets (6a-6j), wherein the cooling system (22) comprises a common cooling stage (8) for all superconductor bulk sub-magnets (6a-6j) of the superconductor bulk magnet (5),

wherein a first superconductor bulk sub-magnet (6a, 6f) of the stack (18, 19) located at one end of the stack (18, 19) is thermally linked to the cooling stage (8) only via a non-adjustable first thermal impedance (7a, 7f), wherein the superconductor bulk sub-magnets (6a-6j) of the stack (18, 19) are thermally linked to each other in a linear sequence via non-adjustable intermediate thermal impedances (7b-7e; 7g-7j),

wherein the superconductor bulk sub-magnets (6b-6e, 6g-6j) farther away from the cooling stage (8) in the linear sequence than the first superconductor bulk sub-magnet (6a, 6f) are thermally linked to the cooling stage (8) only through the superconductor bulk sub-magnets (6b-6e, 6g-6j) and the non-adjustable intermediate thermal impedances (7b-7e; 7g-7j) closer to the cooling stage (8) in the linear sequence and the non-adjustable first thermal impedance (7a, 7f),

**characterized in**

**that** the cooling system (22) is adapted to individually set temperatures $T_n$ of the N superconductor bulk sub-magnets (6a-6j),

wherein for each superconductor bulk sub-magnet (6a-6j) there is a heater element (15) thermally linked to the respective superconductor bulk sub-magnet (6a-6j).

13. A superconductor magnet system (2) according to claim 12, **characterized in that** for each superconductor bulk sub-magnet (6a-6j), there is a temperature sensor (15) for sensing the respective temperature T of the superconductor bulk sub-magnet (6a-6j).

14. A superconductor magnet system (2) according to claim 12 or 13, **characterized in that** the superconductor bulk magnet (5) comprises at least two radially nested stacks (18, 19) of axially stacked superconductor bulk sub-magnets (6a-6j).

15. Use of a superconductor magnet system (2) according to one of the claims 12 through 14, or of a superconductor magnet system (2) charged in a method according to one of the claims 1 through 11, in a nuclear magnetic resonance measurement.

**Patentansprüche**

1. Verfahren zum Laden eines Supraleitermagnetsystems (2), wobei das Supraleitermagnetsystem (2) umfasst:

   - einen Supraleitermassenmagneten (5), wobei der Supraleitermassenmagnet (5) N Supraleitermassenuntermagnete (6a-6j) umfasst, wobei $N \geq 4$ ist,
   - und ein Kühlsystem (22) für die N Supraleitermassenuntermagnete (6a-6j),
   wobei der Supraleitermassenmagnet (5) in einer Ladebohrung (3a) eines elektrischen Lademagneten (3) angeordnet ist,
   wobei die N Supraleiteruntermagnete (6a-6j) durch einen Feldkühlungsprozess aufgeladen werden, so dass ein Ziel-Dauerstrommuster $\underline{i}^{target} = (i_n^{target}: n=1...N)$ in den Supraleiteruntermagneten (6a-6j) erreicht wird, wobei ein elektrischer Strom $I_{ch}$ in dem elektrischen Lademagneten (3) verändert wird, wobei n: Index des Supraleitermassenuntermagneten,
   **dadurch gekennzeichnet,**
   **dass** das Kühlsystem (22) dafür ausgelegt ist, die Temperaturen $T_n$ der N Supraleitermassenuntermagnete (6a-6j) einzeln einzustellen,
   **dass** während des Feldkühlungsprozesses wenigstens zeitweise die Temperaturen $\underline{T} = (T_n: n=1...N)$ der N Supraleitermassenuntermagnete (6a-6j) voneinander verschieden gewählt werden,
   **dass** bei einer Vorausberechnung die folgenden Schritte zur Anwendung kommen:

   a) eine zeitliche Abfolge von Kühlschritten $cs_k$ wird gewählt, wobei ausgehend von einem Zustand des Supraleitermassenmagneten (5), in dem alle seine Supraleitermassenuntermagnete (6a-6j) über ihrer kritischen Temperatur $T_c$ liegen, in jedem Kühlschritt $cs_k$ der zeitlichen Abfolge ein weiterer Supraleitermassenuntermagnet (6a-6j) unter seine kritische Temperatur $T_c$ gekühlt wird, wobei k: Index der Abfolge, wobei k=1...N;
   b) für jeden Zustand $st_k$ des Supraleitermassenmagneten (5), der nach einem jeweiligen Kühlschritt $cs_k$ erhalten wird, wird eine Verteilung der Temperaturen $\underline{T}(k)$ der Supraleitermassenuntermagnete (6a-6j) bestimmt, wobei $\underline{T}(k) = (T_n(k): n=1..N)$ ist,
   c) für jeden Zustand $st_k$ des Supraleitermassenmagneten (5), der nach einem jeweiligen Kühlschritt $cs_k$ erhalten wird, wird eine Reaktion der Supraleitermassenuntermagneten (6a-6j) auf eine Änderung des Ladestroms $I_{ch}$ berechnet, wobei wenigstens eine Geometrie des Lademagneten (3), eine Geometrie des Supraleitermassenmagneten (5), eine durch den elektrischen Lademagneten (3) erzeugte magnetische Hintergrundflussdichte B und eine kritische Stromdichte $j_c(B, T_n(k))$ der Supraleitermassenuntermagnete (6a-6j) bei ihrer jeweiligen zutreffenden Temperatur $T_n(k)$, die in Schritt b) für den jeweiligen Zustand $st_k$ bestimmt wurde, berücksichtigt werden,
   d) ein Ladestromschrittmuster $\underline{c} = (c_k: k=1...N)$ wird berechnet, mit einem Stromschrittinkrement $c_k := [I_{ch}$(nach dem Stromschritt im Zustand $st_k$) - $I_{ch}$ (vor dem Stromschritt im Zustand $st_k$)]*(-1), wobei mit dem Strom-schrittinkrement $c_k$ des Ladestromschrittmusters c, das im jeweiligen Zustand $st_k$ des Supraleitermassen-magneten (5) anzuwenden ist, so dass sich das Ziel-Dauerstrommuster $\underline{i}^{target} = (i_n^{target}: n=1...N)$ in den Supraleitermassenuntermagneten (6a-6j) ergibt, basierend auf den in Schritt c) berechneten Reaktionen, und dass das Supraleitermagnetsystem (2) dem Feldkühlungsprozess unterzogen wird, wobei die in Schritt a) gewählte zeitliche Abfolge von Kühlschritten $cs_k$ angewendet wird und das in Schritt d) berechnete Ladestromschrittmuster c angewendet wird, wodurch das Ziel-Dauerstrommuster $\underline{i}^{target} = (i_n^{target}: n=1...N)$ im Supraleitermassenmagneten eingerichtet wird.

2. Verfahren gemäß Anspruch 1, **dadurch gekennzeichnet,**

   **dass** in Schritt c) zum Berechnen der Reaktionen ein Test-Ladestromschrittmuster $\underline{c}^{test} = (c^{test}_k: k=1...N)$ mit Test-Stromschrittinkrementen $c^{test}_k$ eines Test-Ladestroms $I^{test}_{ch}$, gewählt wird, wobei $\underline{c}^{test}_k := [I^{test}_{ch}$ (nach dem Stromschritt im Zustand $st_k$) - $I^{test}_{ch}$, (vor dem Stromschritt im Zustand $st_k$)]*(-1) ist, wobei Dauerströme, die sich in den Supraleitermassenuntermagneten (6a-6j) infolge der anschließenden Anwendung der Test-Strom-schrittinkremente $c^{test}_k$ in den Zuständen $st_k$ ansammeln, berechnet werden,
   und **dass** für jedes Test-Stromschrittinkrement $c^{test}_k$ eine Änderung $cp_{k,n}$ des Dauerstroms in jedem Supraleitermassenuntermagneten n=1...N (6a-6j) im Zustand $st_k$ berechnet wird, und eine Reaktion $M_{k,n}$ des Supraleitermassenuntermagneten n (6a-6j) im Zustand $st_k$ bestimmt wird, wobei $M_{k,n} = cp_{k,n}/c^{test}_k$.

3. Verfahren gemäß Anspruch 2, **dadurch gekennzeichnet, dass** eine Reaktionsmatrix **M** berechnet wird, wobei $\mathbf{M} = (M_{k,n}: k=1...N \text{ und } n=1...N)$,

und dass in Schritt d) zum Berechnen des Ladestromschrittmusters c für das Ziel-Dauerstrommuster $\underline{i}^{target}$ das lineare Gleichungssystem $\underline{i}^{target}=\mathbf{M}*\underline{c}$ nach c aufgelöst wird.

4. Verfahren gemäß Anspruch 3, **dadurch gekennzeichnet, dass** in Schritt d) zum Berechnen des Ladestromschrittmusters c für das Ziel-Dauerstrommuster $\underline{i}^{target}$ eine Kehrmatrix $\mathbf{Z}:=inv(\mathbf{M})$ berechnet wird, und c bestimmt wird mit $\underline{c}=\mathbf{Z}*\underline{i}^{target}$.

5. Verfahren gemäß einem der Ansprüche 2 bis 4, **dadurch gekennzeichnet, dass** in Schritt c) ein erstes Modell angewendet wird, welches beinhaltet:

   - Unterteilen eines jeden Supraleitermassenuntermagneten (6a-6j) in mehrere radial verschachtelte und axial gestapelte Schichten (12), und
   - Berechnen von Schichtdauerströmen, die sich in den Schichten (12) infolge der anschließenden Anwendung der Test-Stromschrittinkremente $c^{test}_k$ des Test-Ladestromschrittmusters $\underline{c}^{test}$ ansammeln,

   und ferner dass ein zweites Modell angewendet wird, was beinhaltet:

   - für jeden Supraleitermassenuntermagneten n (6a-6j) nach Anwendung eines jeden Test-Stromschrittinkre-ments $c^{test}_k$, Addieren der Schichtdauerströme aller Schichten (12), die zu dem betreffenden Supraleitermassenuntermagneten n (6a-6j) gehören, zu einem addierten Dauerstrom, und Bestimmen der Änderungen des Dauerstroms $cp_{k,n}$ anhand der addierten Dauerströme.

6. Verfahren gemäß einem der Ansprüche 2 bis 5, **dadurch gekennzeichnet, dass** das Verfahren mehrere Iterationen umfasst, umfassend

   - eine erste Iteration beinhaltend Schritt a), Schritt b), Schritt c) und Schritt d),
   - optional eine oder mehrere zwischengeschobene Iterationen beinhaltend Schritt c) und Schritt d) und
   - eine letzte Iteration beinhaltend Schritt c) und optional Schritt d),
   dass in der ersten Iteration, in Schritt c), das Test-Ladestromschrittmuster $\underline{c}^{test}$ willkürlich gewählt wird, insbesondere mit gleichen Test-Stromschrittinkrementen $c^{test}_k$,
   dass in einer oder mehreren anschließenden Iterationen das Ladestromschrittmuster c, das aus Schritt d) der vorherigen Iteration resultiert, als Test-Ladestromschrittmuster $\underline{c}^{test}$ in Schritt c) der aktuellen Iteration verwendet wird,
   und dass, wenn das Supraleitermagnetsystem (2) dem Feldkühlungsprozess unterzogen wird, das Ladestrom-schrittmuster $\underline{c}$ angewendet wird, das in Schritt d) einer letzten Iteration, welche Schritt d) beinhaltete, berechnet wurde.

7. Verfahren gemäß Anspruch 6, **dadurch gekennzeichnet, dass**

   α) die letzte Iteration einen Schritt d) beinhaltet, und wenn eine Differenz zwischen einem Ladestromschritt-muster $\underline{c}$ der aktuellen Iteration und einem Ladestromschrittmuster $\underline{c}$ der vorherigen Iteration größer als ein Schwellenwert ist, dann wird eine weitere Iteration durchgeführt, andernfalls ist die aktuelle Iteration die letzte Iteration und es wird keine weitere Iteration durchgeführt, oder
   β) für jede Iteration in Schritt c) ein Test-Ziel-Dauerstrommuster $\underline{i}^{test,target}=(i_n^{test,target}: n=1...N)$ in den Supraleitermassenuntermagneten (6a-6j) berechnet wird, basierend auf dem Test-Ladestromschrittmuster $\underline{c}^{test}$ der ak-tuellen Iteration, und wenn eine Differenz zwischen dem Test-Ziel-Dauerstrommuster $\underline{i}^{test,target}$ der aktuellen Iteration und dem Test-Ziel-Dauerstrommuster $\underline{i}^{test,target}$ der vorherigen Iteration größer als ein Schwellenwert ist, dann wird eine weitere Iteration durchgeführt, andernfalls ist die aktuelle Iteration die letzte Iteration und es wird keine weitere Iteration durchgeführt, insbesondere wobei die letzte Iteration keinen Schritt d) beinhaltet, oder
   γ) für jede Iteration in Schritt c) ein Test-Ziel-Dauerstrommuster $\underline{i}^{test,target}=(i_n^{test,target}: n=1...N)$ in den Supraleitermassenuntermagneten (5) berechnet wird, basierend auf dem Test-Ladestromschrittmuster $\underline{c}^{test}$ der aktuellen Iteration, und wenn eine Differenz zwischen dem Test-Ziel-Dauerstrommuster $\underline{i}^{test,target}$ der aktuellen Iteration und dem Ziel-Dauerstrommuster $\underline{i}^{target}$ größer als ein Schwellenwert ist, dann wird eine weitere Iteration durchgeführt, andernfalls ist die aktuelle Iteration die letzte Iteration und es wird keine weitere Iteration durchgeführt, insbesondere wobei die letzte Iteration keinen Schritt d) beinhaltet.

8. Verfahren gemäß einem der vorstehenden Ansprüche, **dadurch gekennzeichnet,**

**dass** der Supraleitermassenmagnet (5) mit wenigstens einem Stapel (18, 19) von axial gestapelten Supraleitermassenuntermagneten (6a-6j) gewählt wird, die in linearer Folge über thermische Impedanzen (7a-7j) thermisch verbunden sind, wobei ein endseitiger Supraleitermassenuntermagnet (6a, 6f) des Stapels (18, 19) thermisch mit einer Kühlstufe (8) verbunden ist,

und **dass** in Schritt a) die zeitliche Abfolge der Kühlschritte $cs_k$ so gewählt wird, dass in einem jeweiligen Stapel (18, 19) die Supraleitermassenuntermagnete (6a-6j) der linearen Abfolge, die näher an der Kühlstufe (8) liegen, vor den Supraleitermassenuntermagneten (6a-6j) der linearen Abfolge, die weiter von der Kühlstufe (8) entfernt sind, unter ihre kritische Temperatur $T_c$ gekühlt werden.

9. Verfahren gemäß einem der vorstehenden Ansprüche, **dadurch gekennzeichnet, dass** der Supraleitermassenmagnet (5) mit wenigstens zwei radial verschachtelten Stapeln (18, 19) von axial gestapelten Supraleitermassenuntermagneten (6a-6j) gewählt wird, und dass in Schritt a) die zeitliche Abfolge der Kühlschritte $cs_k$ so gewählt wird, dass Supraleitermassenuntermagnete (6a-6e) eines Stapels (18), der radial weiter innen liegt, vor Supraleitermassenuntermagneten (6a-6j) eines Stapels (19), der radial weiter außen liegt, unter ihre kritische Temperatur $T_c$ gekühlt werden.

10. Verfahren gemäß einem der vorstehenden Ansprüche, **dadurch gekennzeichnet, dass** in Schritt b) die Verteilungen $\underline{T}(k)$ der Temperaturen der Supraleitermassenuntermagnete (6a-6j) in den Zuständen $st_k$ für die in Schritt a) gewählte zeitliche Abfolge von Kühlschritten $cs_k$ experimentell bestimmt werden, wobei Temperatursensoren (15) an den Supraleitermassenuntermagneten (6a-6j) ausgelesen werden, und wobei Steuerparameter des Kühlsystems (22), die zum Herstellen der zeitlichen Abfolge der Kühlschritte $cs_k$ verwendet werden, aufgezeichnet werden, und dass, wenn das Supraleitermagnetsystem (2) dem Feldkühlungsprozess unterzogen wird, die zeitliche Abfolge der Schritte $cs_k$ von Schritt a) unter Verwendung derselben Steuerparameter des Kühlsystems (22) angewendet wird.

11. Verfahren gemäß einem der vorstehenden Ansprüche, **dadurch gekennzeichnet, dass**, nachdem das Ziel-Dauerstrommuster $\underline{i}^{target} = (i_n^{target}: n=1...N)$ im Supraleitermassenmagneten (5) durch den Feldkühlungsprozess hergestellt worden ist, dann ein Hauptfeldkühlungsprozess durchgeführt wird,

dass während des Hauptfeldkühlungsprozesses alle N Supraleitermassenuntermagnete (6a-6j) unter ihrer kritischen Temperatur $T_c$ liegen, und der Ladestrom $I_{ch}$ weiter variiert wird, insbesondere auf null reduziert wird, so dass der Hauptfeldkühlungsprozess ein Hauptdauerstrommuster $\underline{h} = (h_n: n=1...N)$ dem Ziel-Dauerstrommuster $\underline{i}^{target} = (i_n: n=1...N)$ in den Supraleitermassenuntermagneten (6a-6j) hinzufügt, und dass das Ziel-Dauerstrommuster $\underline{i}^{target} = (i_n^{target}: n=1...N)$ so gewählt wurde, dass ein Magnetfeld in einem Probenvolumen (11) des Supraleitermassenmagneten (5) basierend auf einem Summenstrommuster $\underline{s} = \underline{i}^{target} + \underline{h}$ homogener ist als ein Magnetfeld im Probenvolumen (11) des Supraleitermassenmagneten (5), das sich basierend auf dem Hauptdauerstrommuster h allein ergeben würde.

12. Supraleitermagnetsystem (2), umfassend:

- einen Supraleitermassenmagneten (5), wobei der Supraleitermassenmagnet (5) N Supraleitermassenuntermagnete (6a-6j) umfasst,
- und ein Kühlsystem (22) für die N Supraleitermassenuntermagnete (6a-6j),
wobei der Supraleitermassenmagnet (5) wenigstens einen Stapel (18, 19) von axial gestapelten Supraleitermassenuntermagneten (6a-6j) umfasst, wobei das Kühlsystem (22) eine gemeinsame Kühlstufe (8) für alle Supraleitermassenuntermagnete (6a-6j) des Supraleitermassenmagneten (5) umfasst, wobei ein erster Supraleitermassenuntermagnet (6a, 6f) des Stapels (18, 19), der sich an einem Ende des Stapels (18, 19) befindet, nur über eine nicht einstellbare erste thermische Impedanz (7a, 7f) thermisch mit der Kühlstufe (8) verbunden ist, wobei die Supraleitermassenuntermagnete (6a-6j) des Stapels (18, 19) in einer linearen Abfolge über nicht einstellbare thermische Zwischenimpedanzen (7b-7e; 7g-7j) thermisch miteinander verbunden sind, wobei die Supraleitermassenuntermagnete (6b-6e, 6g-6j), die in der linearen Abfolge weiter von der Kühlstufe (8) entfernt sind als der erste Supraleitermassenuntermagnet (6a, 6f), mit der Kühlstufe (8) nur über die Supraleitermassenuntermagnete (6b-6e, 6g-6j) und die nicht einstellbaren thermischen Zwischenimpedanzen (7b-7e; 7g-7j), die in der linearen Abfolge näher an der Kühlstufe (8) liegen, und die nicht einstellbare erste thermische Impedanz (7a, 7f) thermisch verbunden sind, **dadurch gekennzeichnet,** **dass** das Kühlsystem (22) dafür ausgelegt ist, die Temperaturen $T_n$ der N Supraleitermassenuntermagnete (6a-6j) einzeln einzustellen,

wobei für jeden Supraleitermassenuntermagneten (6a-6j) ein Heizelement (15) vorhanden ist, das thermisch mit dem jeweiligen Supraleitermassenuntermagneten (6a-6j) verbunden ist.

13. Supraleitermagnetsystem (2) gemäß Anspruch 12, **dadurch gekennzeichnet, dass** für jeden Supraleitermassenuntermagneten (6a-6j) ein Temperatursensor (15) zum Erfassen der jeweiligen Temperatur T des Supraleitermassenuntermagneten (6a-6j) vorhanden ist.

14. Supraleitermagnetsystem (2) gemäß Anspruch 12 oder 13, **dadurch gekennzeichnet, dass** der Supraleitermassenmagnet (5) wenigstens zwei radial verschachtelten Stapel (18, 19) von axial gestapelten Supraleitermassenuntermagneten (6a-6j) umfasst.

15. Verwendung eines Supraleitermagnetsystems (2) gemäß einem der Ansprüche 12 bis 14 oder eines Supraleitermagnetsystems (2), das in einem Verfahren gemäß einem der Ansprüche 1 bis 11 geladen wurde, in einer Kernmagnetresonanzmessung.

**Revendications**

1. Procédé de charge d'un système (2) d'aimant supraconducteur,

   le système (2) d'aimant supraconducteur comportant

   - un aimant supraconducteur massif (5), l'aimant supraconducteur massif (5) comportant N aimants élémentaires supraconducteurs massifs (6a-6j), avec N≥4,
   - et un système (22) de refroidissement pour les N aimants élémentaires supraconducteurs massifs (6a-6j), l'aimant supraconducteur massif (5) étant disposé dans un alésage (3a) de charge d'un électroaimant (3) de charge,

   les N aimants élémentaires supraconducteurs massifs (6a-6j) étant chargés par un processus de refroidissement de champ, de telle façon qu'un motif cible de courant persistant $\underline{i}^{target}$= ($i_n^{target}$ : n=1...N) dans les aimants élémentaires supraconducteurs massifs (6a-6j) soit réalisé, un courant électrique $I_{ch}$ dans l'électroaimant (3) de charge étant modifié, avec n : indice d'aimant élémentaire supraconducteur massif,
   **caractérisé**
   **en ce que** le système (22) de refroidissement est prévu pour régler individuellement des températures $T_n$ des N aimants élémentaires supraconducteurs massifs (6a-6j), en ce que, pendant le processus de refroidissement de champ, les températures $\underline{T}$=($T_n$ : n=1...N) des N aimants élémentaires supraconducteurs massifs (6a-6j) sont au moins temporairement choisies différentes les unes des autres,
   **en ce que** dans un calcul anticipé, les étapes suivantes sont appliquées :

   a) une séquence temporelle d'étapes de refroidissement $cs_k$ est choisie, à partir d'un état de l'aimant supraconducteur massif (5) où tous ses aimants élémentaires supraconducteurs massifs (6a-6j) se trouvent au-dessus de leur température critique $T_c$, à chaque étape de refroidissement $cs_k$ de la séquence temporelle, un aimant élémentaire supraconducteur massif (6a-6j) de plus étant refroidi au-dessous de sa température critique $T_c$, avec k : indice de séquence, avec k=1...N ;
   b) pour chaque état $st_k$ de l'aimant supraconducteur massif (5) obtenu après une étape respective de refroidissement $cs_k$, une répartition de températures T(k) des aimants élémentaires supraconducteurs massifs (6a-6j) est déterminée, avec $\underline{T}$(k)=($T_n$(k) :n=1...N),
   c) pour chaque état $st_k$ de l'aimant supraconducteur massif (5) obtenu après une étape respective de refroidissement $cs_k$, une réponse des aimants élémentaires supraconducteurs massifs (6a-6j) à une modification du courant de charge $I_{ch}$ est calculée, en tenant compte au moins d'une géométrie de l'aimant (3) de charge, d'une géométrie de l'aimant supraconducteur massif (5), d'une densité B de flux magnétique de fond générée par l'électroaimant (3) de charge, et d'une densité de courant critique $j_c$(B, $T_n$(k)) des aimants élémentaires supraconducteurs massifs (6a-6j) à leur température applicable $T_n$(k) déterminée à l'étape b) pour l'état $st_k$ considéré,
   d) un motif c=($c_k$ :k=1...N) d'échelons de courant de charge est calculé, avec un incrément d'échelon de courant $c_k$ :=[$I_{ch}$(après l'étape actuelle dans l'état $st_k$) - $I_{ch}$(avant l'étape actuelle dans l'état $st_k$)]*(-1), l'incrément $c_k$ d'échelon de courant du motif c d'échelons de courant de charge à appliquer dans l'état respectif $st_k$ de l'aimant supraconducteur massif (5) étant tel qu'il donne lieu au motif cible de courant persistant

$\underline{i}^{target} = (i_n^{target} : n=1...N)$ dans les aimants élémentaires supraconducteurs massifs (6a-6j), sur la base des réponses calculées à l'étape c),

et **en ce que** le système (2) d'aimant supraconducteur est soumis au processus de refroidissement de champ, en appliquant la séquence temporelle d'étapes de refroidissement $cs_k$ choisie à l'étape a) et en appliquant le motif c d'échelons de courant de charge calculé à l'étape d), établissant ainsi le motif cible de courant persistant $\underline{i}^{target} = (i_n^{target} : n=1...N)$ dans l'aimant supraconducteur massif.

2. Procédé selon la revendication 1, **caractérisé en ce qu'**à l'étape c), pour calculer les réponses, un motif d'échelons de courant de charge de test $\underline{c}^{test} = (c^{test}_k : k=1...N)$ d'incréments $c^{test}_k$ d'échelons de courant de test d'un courant de charge de test $I^{test}_{ch}$ est choisi, avec $c^{test}_k = I^{test}_{ch}$ (après l'étape actuelle dans l'état $st_k$) - $I^{test}_{ch}$ (avant l'étape actuelle dans l'état $st_k$)]*(-1), des courants persistants qui s'accumulent dans les aimants élémentaires supraconducteurs massifs (6a-6j) en raison de l'application subséquente des incréments $c^{test}_k$ d'échelons de courant de test dans les états $st_k$ étant calculés, et **en ce que**, pour chaque incrément $c^{test}_k$ d'échelon de courant de test, une variation $cp_{k,n}$ de courant persistant dans chaque aimant élémentaire supraconducteur massif n=1...N (6a-6j) à l'état $st_k$ est calculée, et une réponse $M_{k,n}$ de l'aimant élémentaire supraconducteur massif n (6a-6j) dans l'état $st_k$ est déterminée avec $M_{k,n} = cp_{k,n}/c^{test}_k$.

3. Procédé selon la revendication 2, **caractérisé en ce qu'**une matrice **M** de réponse est calculée, avec **M**=($M_{k,n}$ : k=1...N et n=1...N), et **en ce qu'**à l'étape d), pour calculer le motif c d'échelons de courant de charge pour le motif cible de courant persistant $\underline{i}^{target}$, le système linéaire d'équations $\underline{i}^{target}$-M*$\underline{c}$ est résolu avec $\underline{c}$ comme inconnue.

4. Procédé selon la revendication 3, **caractérisé en ce qu'**à l'étape d), pour calculer le motif c d'échelons de courant de charge pour le motif cible $\underline{i}^{target}$ de courant persistant, une matrice inverse **Z** :=inv(**M**) est calculée, et c est déterminé avec $\underline{c} = \mathbf{Z}*\underline{i}^{target}$.

5. Procédé selon l'une des revendications 2 à 4, **caractérisé en ce qu'**à l'étape c), un premier modèle est appliqué, qui comprend les actions de

   - diviser chaque aimant élémentaire supraconducteur massif (6a-6j) en une pluralité de feuilles (12) imbriquées radialement et empilées axialement, et
   - calculer des courants persistants de feuilles s'accumulant dans les feuilles (12) en raison de l'application subséquente des incréments d'échelons de courant de test $c^{test}_k$ du motif d'échelons de courant de charge de test $\underline{c}^{test}$,

   et **en ce qu'**un second modèle est en outre appliqué, qui comprend les actions consistant

   - pour chaque aimant élémentaire supraconducteur massif n (6a-6j) après application de chaque incrément d'échelon de courant de test $c^{test}_k$, à sommer les courants persistants de feuilles de toutes les feuilles (12) appartenant à l'aimant élémentaire supraconducteur massif n (6a-6j) considéré en un courant persistant sommé, et à déterminer les variations de courant persistant $cp_{k,n}$ à partir des courants persistants sommés.

6. Procédé selon l'une des revendications 2 à 5, **caractérisé en ce que** le procédé comporte une pluralité d'itérations, comportant

   - une première itération incluant l'étape a), l'étape b), l'étape c) et l'étape d),
   - optionnellement une ou plusieurs itérations intermédiaires incluant l'étape c) et l'étape d), et
   - une itération finale incluant l'étape c) et optionnellement l'étape d),
   **en ce que** lors de la première itération, à l'étape c), le motif d'échelons de courant de charge de test $\underline{c}^{test}$ est choisi arbitrairement, en particulier avec des incréments $c^{test}_k$ égaux d'échelons de courant de test,
   **en ce que** lors d'une ou plusieurs itérations subséquentes, le motif $\underline{c}^{test}$ d'échelons de courant de charge résultant de l'étape d) de l'itération précédente est utilisé comme motif d'échelons de courant de charge de test $\underline{c}^{test}$ à l'étape c) de l'itération actuelle,
   et **en ce que** lorsque le système (2) d'aimant supraconducteur est soumis au processus de refroidissement de champ, le motif d'échelons de courant de charge $\underline{c}$ calculée à l'étape d) d'une dernière itération ayant inclus l'étape d) est appliqué.

7. Procédé selon la revendication 6, **caractérisé en ce que**

α) l'itération finale comprend une étape d), et si une différence entre un motif c̲ d'échelons de courant de charge de l'itération actuelle et un motif c̲ d'échelons de courant de charge de l'itération précédente est supérieure à une valeur seuil, alors une autre itération est effectuée, sinon l'itération actuelle est l'itération finale et aucune itération supplémentaire n'est effectuée, ou

β) pour chaque itération, à l'étape c), un motif cible de courant persistant de test $\underline{i}^{test,target}$= ($i_n^{test,target}$ : n=1...N) dans les aimants élémentaires supraconducteurs massifs (6a-6j) est calculé d'après le motif d'échelons de courant de charge de test $\underline{c}^{test}$ de l'itération actuelle, et si une différence entre le motif cible de courant persistant de test $\underline{i}^{test,target}$ de l'itération actuelle et le motif cible de courant persistant de test $\underline{i}^{test,target}$ de l'itération précédente est supérieure à une valeur seuil, alors une autre itération est effectuée, sinon l'itération actuelle est la dernière itération et aucune itération supplémentaire n'est effectuée, en particulier l'itération finale ne comprenant pas d'étape d), ou y) pour chaque itération, à l'étape c) un motif cible de courant persistant de test $\underline{i}^{test,target}$ = ($i_n^{test,target}$ : n=1...N) dans les aimants élémentaires supraconducteurs massifs (5) est calculée d'après le motif $\underline{c}^{test}$ d'échelons de courant de charge de test de l'itération actuelle, et si une différence entre le motif cible $\underline{i}^{test,target}$ de courant persistant de test de l'itération actuelle et le motif cible $\underline{i}^{target}$ de courant persistant est supérieure à une valeur seuil, alors une autre itération est effectuée, sinon l'itération actuelle est l'itération finale et aucune itération supplémentaire n'est effectuée, en particulier l'itération finale ne comprenant pas d'étape d) .

8. Procédé selon l'une des revendications précédentes, **caractérisé en ce que** l'aimant supraconducteur massif (5) est choisie avec au moins une pile (18, 19) d'aimants élémentaires supraconducteurs massifs (6a-6j) empilés axialement, liés thermiquement dans une séquence linéaire par l'intermédiaire d'impédances thermiques (7a-7j), un aimant élémentaire supraconducteur massif (6a, 6f) côté extrémité de la pile (18, 19) étant lié thermiquement à une platine (8) de refroidissement, et **en ce qu'**à l'étape a) la séquence temporelle d'étapes cs_k de refroidissement est choisie de telle façon que dans une pile (18, 19) respective, des aimants élémentaires supraconducteurs massifs (6a-6j) de la séquence linéaire plus proches de la platine (8) de refroidissement soient refroidis au-dessous de leur température critique $T_c$ avant des aimants élémentaires supraconducteurs massifs (6a-6j) de la séquence linéaire plus éloignés de la platine (8) de refroidissement.

9. Procédé selon l'une des revendications précédentes, **caractérisé en ce que** l'aimant supraconducteur massif (5) est choisi avec au moins deux piles (18, 19) imbriquées radialement d'aimants élémentaires supraconducteurs massifs (6a-6j) empilés axialement,
et **en ce qu'**à l'étape a), la séquence temporelle d'étapes cs_k de refroidissement est choisie de telle façon que des aimants élémentaires supraconducteurs massifs (6a-6e) d'une pile (18) située radialement plus loin vers l'intérieur soient refroidis au-dessous de leur température critique $T_c$ avant des aimants élémentaires supraconducteurs massifs (6f-6j) d'une pile (19) située radialement plus loin vers l'extérieur.

10. Procédé selon l'une des revendications précédentes, **caractérisé en ce qu'**à l'étape b), les répartitions $\underline{T}(k)$ de températures des aimants élémentaires supraconducteurs massifs (6a-6j) dans les états st_k sont déterminées expérimentalement pour la séquence temporelle d'étapes cs_k de refroidissement choisie à l'étape a), des capteurs thermiques (15) au niveau des aimants élémentaires supraconducteurs massifs (6a-6j) étant lus, et des paramètres de commande du système (22) de refroidissement appliqué servant à établir la séquence temporelle d'étapes de refroidissement cs_k étant enregistrés, et **en ce que**, lorsque le système (2) d'aimant supraconducteur est soumis au processus de refroidissement de champ, la séquence temporelle d'étapes cs_k de l'étape a) est appliquée en utilisant les mêmes paramètres de commande du système (22) de refroidissement.

11. Procédé selon l'une des revendications précédentes, **caractérisé en ce qu'**après que le motif cible de courant persistant $\underline{i}^{target}$= ($i_n^{target}$ : n=1...N) a été établi dans l'aimant supraconducteur massif (5) par le processus de refroidissement de champ, un processus principal de refroidissement de champ est ensuite effectué, **en ce que** pendant le processus principal de refroidissement de champ, les N aimants élémentaires supraconducteurs massifs (6a-6j) sont tous au-dessous de leur température critique $T_c$, et le courant de charge $I_{ch}$ fait en outre l'objet de variations, en particulier est réduit à zéro, de telle sorte que le processus principal de refroidissement de champ ajoute un motif principal de courant persistant $\underline{h}$=($h_n$ : n=1...N) au motif cible de courant persistant $\underline{i}^{target}$= ($i_n^{target}$ : n=1...N) dans les aimants élémentaires supraconducteurs massifs (6a-6j), et **en ce que** le motif cible de courant persistant $\underline{i}^{target}$=($i_n^{target}$ : n=1...N) a été choisi de telle façon qu'un champ magnétique dans un volume (11) d'échantillon de l'aimant supraconducteur massif (5) d'après un motif de courant sommé $\underline{s}$=$\underline{i}^{target}$+$\underline{h}$ soit plus homogène qu'un champ magnétique dans le volume (11) d'échantillon de l'aimant supraconducteur massif (5) qui serait engendré sur la base du motif principal h de courant persistant seul.

12. Système (2) d'aimant supraconducteur, comportant

- un aimant supraconducteur massif (5), l'aimant supraconducteur massif (5) comportant N aimants élémentaires supraconducteurs massifs (6a-6j),

- et un système (22) de refroidissement pour les N aimants élémentaires supraconducteurs massifs (6a-6j), l'aimant supraconducteur massif (5) comportant au moins une pile (18, 19) d'aimants élémentaires supraconducteurs massifs (6a-6j) empilés axialement,

le système (22) de refroidissement comportant une platine (8) de refroidissement commune pour tous les aimants élémentaires supraconducteurs massifs (6a-6j) de l'aimant supraconducteur massif (5),

un premier aimant élémentaire supraconducteur massif (6a, 6f) de la pile (18, 19) situé à une extrémité de la pile (18, 19) n'étant lié thermiquement à la platine (8) de refroidissement que par l'intermédiaire d'une première impédance thermique (7a, 7f) non réglable,

les aimants élémentaires supraconducteurs massifs (6a-6j) de la pile (18, 19) étant liés thermiquement les uns aux autres dans une séquence linéaire via des impédances thermiques intermédiaires (7b-7e ; 7g-7j) non réglables, les aimants élémentaires supraconducteurs massifs (6b-6e, 6g-6j) plus éloignés de la platine (8) de refroidissement dans la séquence linéaire que le premier aimant élémentaire supraconducteur massif (6a, 6f) n'étant liés thermiquement à la platine (8) de refroidissement qu'à travers les aimants élémentaires supraconducteurs massifs (6b-6e, 6g-6j) et les impédances thermiques intermédiaires (7b-7e ; 7g-7j) non réglables plus proches de la platine (8) de refroidissement dans la séquence linéaire et la première impédance thermique (7a, 7f) non réglable,

**caractérisé**

**en ce que** le système (22) de refroidissement est prévu pour régler individuellement des températures $T_n$ des N aimants élémentaires supraconducteurs massifs (6a-6j), pour chaque aimant élémentaire supraconducteur massif (6a-6j) un élément chauffant (15) étant présent, lié thermiquement à l'aimant élémentaire supraconducteur massif (6a-6j) considéré.

13. Système (2) d'aimant supraconducteur selon la revendication 12, **caractérisé en ce que** pour chaque aimant élémentaire supraconducteur massif (6a-6j), il existe un capteur (15) de température servant à détecter la température respective T de l'aimant élémentaire supraconducteur massif (6a-6j).

14. Système (2) d'aimant supraconducteur selon la revendication 12 ou 13, **caractérisé en ce que** l'aimant supraconducteur massif (5) comporte au moins deux piles (18, 19) imbriquées radialement d'aimants élémentaires supraconducteurs massifs (6a-6j) empilés axialement.

15. Utilisation d'un système (2) d'aimant supraconducteur selon l'une des revendications 12 à 14, ou d'un système (2) d'aimant supraconducteur chargé dans un procédé selon l'une des revendications 1 à 11, dans une mesure de résonance magnétique nucléaire.

Fig. 1b

Fig. 1a

Fig. 2

Fig. 3

$$M^0 = \begin{pmatrix}
2127.68 & 1624.53 & 1597.18 & 1586.68 & 1581.25 & 256.87 & 223.27 & 221.78 & 220.98 & 220.42 \\
0.00 & 1626.20 & 1144.50 & 1121.29 & 1112.91 & 723.46 & 27.02 & -2.06 & -2.06 & -2.05 \\
0.00 & 0.00 & 1599.26 & 1121.35 & 1098.28 & 1025.78 & 712.58 & 26.98 & -2.23 & -2.23 \\
0.00 & 0.00 & 0.00 & 1589.09 & 1112.96 & 1086.79 & 1034.79 & 724.39 & 28.94 & -2.01 \\
0.00 & 0.00 & 0.00 & 0.10 & 1584.20 & 1568.33 & 1547.21 & 1488.19 & 1147.47 & 222.09 \\
0.00 & 0.00 & 0.00 & 0.00 & 0.00 & 2189.71 & 1762.05 & 1734.24 & 1722.74 & 1715.68 \\
0.00 & 0.00 & 0.00 & 0.00 & 0.00 & 0.00 & 1591.24 & 1185.63 & 1161.84 & 1151.35 \\
0.00 & 0.00 & 0.00 & 0.00 & 0.00 & 0.00 & 0.00 & 1564.60 & 1157.27 & 1130.50 \\
0.00 & 0.00 & 0.00 & 0.00 & 0.00 & 0.00 & 0.00 & 0.00 & 1583.76 & 1151.31 \\
0.00 & 0.00 & 0.00 & 0.00 & 0.00 & 0.00 & 0.00 & 0.00 & 0.45 & 1717.24
\end{pmatrix}$$

## Fig. 4

$$Z^0 = 1\mathrm{e}{-6} * \begin{pmatrix}
470.00 & -469.51 & -133.38 & -43.87 & -16.00 & 195.70 & -170.87 & -116.85 & -56.12 & -25.45 \\
0.00 & 614.93 & -440.07 & -123.36 & -40.23 & 93.03 & 202.96 & -153.13 & -106.59 & -51.53 \\
0.00 & 0.00 & 625.29 & -441.23 & -123.52 & 14.54 & 110.92 & 210.82 & -152.77 & -108.99 \\
0.00 & 0.00 & 0.00 & 629.32 & -442.12 & 4.32 & 15.86 & 112.36 & 210.44 & -172.09 \\
0.00 & 0.00 & 0.00 & -0.04 & 631.26 & -452.11 & -113.13 & -13.56 & 127.21 & 369.54 \\
0.00 & 0.00 & 0.00 & 0.00 & 0.00 & 456.68 & -505.71 & -122.98 & -35.91 & -12.17 \\
0.00 & 0.00 & 0.00 & 0.00 & 0.00 & 0.00 & 628.44 & -476.22 & -113.03 & -32.06 \\
0.00 & 0.00 & 0.00 & 0.00 & 0.00 & 0.00 & 0.00 & 639.14 & -467.00 & -107.67 \\
0.00 & 0.00 & 0.00 & 0.00 & 0.00 & 0.00 & 0.00 & 0.00 & 631.53 & -423.40 \\
0.00 & 0.00 & 0.00 & 0.00 & 0.00 & 0.00 & 0.00 & 0.00 & -0.17 & 582.44
\end{pmatrix}$$

EP 4 080 527 B1

```
┌─────────────────────┐              ┌─────────────────────┐
│  Choose activation  │──────────────▶│ Determine therm.    │
│     sequence        │              │ profile             │
│                     │              │ T(t) experimentally │
└─────────────────────┘              └─────────────────────┘
          ╲                                      │  ╲___ 200
           ╲___                                  ▼
            100                        ┌─────────────────────┐
                                       │ Set initial test    │
                                       │ conditions:         │
                                       │ T(k), c^test        │
                                       └─────────────────────┘
                                                 │  ╲___ 300
                                                 ▼
                                       ┌─────────────────────┐
                      ┌───────────────▶│ Calculation of      │       Fig. 5a
                      │                │ persistent          │
                      │                │ currents i(k) in    │
                      │                │ bulk rings          │
                      │                └─────────────────────┘
                      │                          │  ╲__ 400
                      │                          ▼
                      │                ┌─────────────────────┐
                      │                │ Evaluate response   │
                      │                │ matrix              │
                      │                │ M and inverse Z     │
                      │                └─────────────────────┘
           Next       │                          │  ╲__ 500
         iteration    │                          ▼
                      │                ┌─────────────────────┐ ___ 600
                      │                │ Determine new test  │
                      │                │ conditions c = Z i^target │
                      │                └─────────────────────┘
                      │                          │
                      │                          ▼
                      │                         ╱ Not ╲                    ___ 800
                      │               NO      ╱ first loop and ╲  YES   ┌──────────────────┐
                      └──────────────────────◀  Good enough    ▶───────▶│ Use last charger │
                                               ╲       ?       ╱  No     │ step pattern c   │
                                                ╲             ╱  further  │ for preparatory  │
                                                 ╲_____╱   iteration│ step of          │
                                                      ╲___ 700            │ field-cooling    │
                                                                          └──────────────────┘
```

Choose activation sequence — 100

Determine therm. profile $\underline{T}(t)$ experimentally — 200

Set initial test conditions: $\underline{T}(k)$, $\underline{c}^{test}$ — 300

Calculation of persistent currents $\underline{i}(k)$ in bulk rings — 400

Not first loop and Good enough? — 701

Determine new test conditions $\underline{c} = \mathbf{Z}^{-1}\underline{i}^{target}$ — 601

Evaluate response matrix $\mathbf{M}$ and inverse $\mathbf{Z}$ — 501

Use last charger step pattern $\underline{c}$ for preparatory step of field-cooling — 801

Next iteration

NO

YES

No further iteration

Fig. 5b

Fig. 6

EP 4 080 527 B1

Fig. 7

EP 4 080 527 B1

EP 4 080 527 B1

1.- ILL: inner stack, lowest lower

2.- IL: inner stack, lower

3.- IM: inner stack, middle

4.- IU: inner stack, upper

5.- IUU: inner stack, uppermost upper

6.- OLL: outer stack, lowest lower

7.- OL: outer stack, lower

8.- OM: outer stack, middle

9.- OU: outer stack, upper

10.- OUU: outer stack, uppermost upper

# Fig. 8

Fig. 9

$$M^1 = \begin{pmatrix}
2127.68 & 1626.56 & 1599.13 & 1588.62 & 1583.04 & 284.71 & 222.79 & 221.62 & 220.59 & 217.47 \\
0.00 & 1625.04 & 1143.54 & 1120.58 & 1111.82 & 738.78 & 23.20 & -5.65 & -5.90 & -8.64 \\
0.00 & 0.00 & 1599.06 & 1121.21 & 1098.04 & 1029.59 & 711.59 & 25.28 & -4.22 & -6.16 \\
0.00 & 0.00 & 0.00 & 1588.83 & 1112.69 & 1090.12 & 1034.12 & 723.54 & 27.49 & -5.25 \\
0.00 & 0.00 & 0.00 & 0.09 & 1584.51 & 1562.33 & 1548.59 & 1489.47 & 1148.62 & 222.13 \\
0.00 & 0.00 & 0.00 & 0.00 & 0.00 & 2161.82 & 1764.46 & 1736.33 & 1725.00 & 1719.80 \\
0.00 & 0.00 & 0.00 & 0.00 & 0.00 & 0.00 & 1593.00 & 1186.93 & 1163.25 & 1154.43 \\
0.00 & 0.00 & 0.00 & 0.00 & 0.00 & 0.00 & 0.00 & 1566.05 & 1158.85 & 1133.75 \\
0.00 & 0.00 & 0.00 & 0.00 & 0.00 & 0.00 & 0.00 & 0.00 & 1584.71 & 1153.82 \\
0.00 & 0.00 & 0.00 & 0.00 & 0.00 & 0.00 & 0.00 & 0.00 & 0.45 & 1718.76
\end{pmatrix}$$

## Fig. 10

$$z^1 = 1e\text{-}6 * \begin{pmatrix}
470.00 & -470.44 & -133.59 & -43.87 & -16.08 & 196.24 & -172.45 & -117.36 & -56.30 & -25.68 \\
0.00 & 614.93 & -440.07 & -123.36 & -40.23 & 93.03 & 202.96 & -153.13 & -106.59 & -51.53 \\
0.00 & 0.00 & 625.29 & -441.23 & -123.52 & 14.54 & 110.92 & 210.82 & -152.77 & -108.99 \\
0.00 & 0.00 & 0.00 & 629.32 & -442.12 & 4.32 & 15.86 & 112.36 & 210.44 & -172.09 \\
0.00 & 0.00 & 0.00 & -0.04 & 631.26 & -452.11 & -113.13 & -13.56 & 127.21 & 369.54 \\
0.00 & 0.00 & 0.00 & 0.00 & 0.00 & 456.68 & -505.71 & -122.98 & -35.91 & -12.17 \\
0.00 & 0.00 & 0.00 & 0.00 & 0.00 & 0.00 & 628.44 & -476.22 & -113.03 & -32.06 \\
0.00 & 0.00 & 0.00 & 0.00 & 0.00 & 0.00 & 0.00 & 639.14 & -467.00 & -107.67 \\
0.00 & 0.00 & 0.00 & 0.00 & 0.00 & 0.00 & 0.00 & 0.00 & 631.53 & -423.40 \\
0.00 & 0.00 & 0.00 & 0.00 & 0.00 & 0.00 & 0.00 & 0.00 & -0.17 & 582.44
\end{pmatrix}$$

Fig. 11

Fig. 12

Fig. 13a

EP 4 080 527 B1

HT

H
T

= ⌐⌐⌐ʌⱯ⌐ + ▨

14

15

Fig. 13b

46

**EP 4 080 527 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20190178961 A1
- US 7859374 B2
- EP 3657193 B1
- US 8948829 B2
- EP 20174683 A
- WO 2016161336 A1
- JP 5143006 B

### Non-patent literature cited in the description

- *LTspice,* 29 March 2021, https://www.analog.com/en/design-center/design-tools-and-calculators/ltspice-simulator.html